# EUROPEAN PATENT APPLICATION

(11) **EP 4 739 057 A1**
(43) Date of publication of application: **06.05.2026**
(21) Application number: 25204045.6
(22) Date of filing: 23.09.2025
(51) Int. Cl.: H10K 59/80, H10K 50/826

(54) **LIGHT EMITTING ELEMENT, ELECTRONIC DEVICE INCLUDING THE SAME, AND METHOD FOR MANUFACTURING THE LIGHT EMITTING ELEMENT**

(30) Priority: 01.11.2024 KR 20240153314
(71) Applicant: Samsung Display Co., Ltd., Yongin-si, Gyeonggi-do (KR)
(72) Inventor: KIM, Hwi, Yongin-si (KR); SON, Ji-Hee, Yongin-si (KR); LEE, Seoulki, Yongin-si (KR); LEE, Joongu, Yongin-si (KR)
(74) Representative: Marks & Clerk LLP

(57) **Abstract**

A light-emitting element includes a first electrode, a functional layer disposed on the first electrode, a second electrode on the functional layer, and a capping layer on the second electrode. The second electrode includes a first layer on the functional layer, a second layer disposed on the first layer and including a different material from that of the first layer, and a third layer disposed on the second layer and including a different material from that of the second layer. The second layer includes sub-layers each including silver (Ag). The sub-layers include a first sub-layer on the first layer, a second sub-layer on the first sub-layer, and a third sub-layer on the second sub-layer. A film density of the first sub-layer and a film density of the second sub-layer are different, and the film density of the second sub-layer and a film density of the third sub-layer are different.

## Description

### BACKGROUND

### 1. Field

The disclosure herein relates to a light-emitting element, an electronic device including the same, and a method for manufacturing the light-emitting element.

### 2. Description of the Related Art

Recently, organic electroluminescence display devices are being actively developed as image display devices. The organic electroluminescence display devices are different from liquid crystal display devices and the like, and are so-called self-emissive display devices in which holes and electrons injected from first electrodes and second electrodes are recombined in emission layers so that light-emitting materials including organic compounds in the emission layers emit light to implement display.

High luminous efficiency and long lifespan of the light-emitting elements are desired for application of the light-emitting elements to the display devices, and materials and structures of the light-emitting elements, which may stably achieve the desires, are continuously being developed.

### SUMMARY

The disclosure provides a light-emitting element with improved luminous efficiency and element lifespan, and an electronic device including the light-emitting element.

The disclosure also provides a method for manufacturing a light-emitting element, the method having a reduced process time and improved element reliability.

An embodiment of the inventive concept provides a light-emitting element including a first electrode, a functional layer disposed on the first electrode and including an emission layer, a second electrode disposed on the functional layer, and a capping layer disposed on the second electrode. The second electrode includes a first layer disposed on the functional layer, a second layer disposed on the first layer and including a different material from that of the first layer, and a third layer disposed on the second layer and including a different material from that of the second layer. The second layer includes a plurality of sub-layers each including silver (Ag), and the plurality of sub-layers include a first sub-layer disposed on the first layer, a second sub-layer disposed on the first sub-layer, and a third sub-layer disposed on the second sub-layer. A film density of the first sub-layer and a film density of the second sub-layer are different, and the film density of the second sub-layer and a film density of the third sub-layer are different.

In an embodiment, the film density of the second sub-layer may be lower than the film density of each of the first sub-layer and the third sub-layer, and the film density of the first sub-layer and the film density of the third sub-layer may be substantially the same.

In an embodiment, the film density of the second sub-layer may be higher than the film density of each of the first sub-layer and the third sub-layer, and the film density of the first sub-layer and the film density of the third sub-layer may be substantially the same.

In an embodiment, the plurality of sub-layers may further include a fourth sub-layer disposed on the third sub-layer, and a fifth sub-layer disposed on the fourth sub-layer. The film density of the third sub-layer and a film density of the fourth sub-layer may be different, and the film density of the fourth sub-layer and a film density of the fifth sub-layer may be different.

In an embodiment, the second sub-layer may be directly disposed on the first sub-layer, and the third sub-layer may be directly disposed on the second sub-layer.

In an embodiment, the first sub-layer, the second sub-layer, and the third sub-layer may have a shape of a single body.

In an embodiment, the first layer may be directly disposed on the functional layer, the second layer may be directly disposed on the first layer, and the third layer may be directly disposed on the second layer.

In an embodiment, the functional layer may include a hole transport region disposed on the first electrode, the emission layer disposed on the hole transport region, and an electron transport region disposed on the emission layer. The first layer may be directly disposed on the electron transport region, and the capping layer may be directly disposed on the third layer.

In an embodiment, the second electrode may be a cathode.

In an embodiment, the first electrode may include at least one metal selected from metals including Ag, Mg, Cu, Al, Pt, Pd, Au, Ni, Nd, Ir, Cr, Li, Ca, LiF, Mo, Ti, W, In, Sn, and Zn, a compound of two or more selected from the metal, or at least one of indium tin oxide ("ITO"), indium zinc oxide ("IZO"), zinc oxide (ZnO), or indium tin zinc oxide ("ITZO").

In an embodiment, the first sub-layer may have a thickness of about 20 angstroms (Å) to about 30 Å, the second sub-layer may have a thickness of about 50 Å to about 70 Å, and the third sub-layer may have a thickness of about 20 Å to about 30 Å.

In an embodiment, the first layer may have a thickness of about 5 Å to about 30 Å, the second layer may have a thickness of about 90 Å to about 300 Å, and the third layer may have a thickness of about 5 Å to about 30 Å.

In an embodiment, each of the first layer and the third layer may include a halogenated metal, a lanthanum group metal, or a co-deposition material of the halogenated metal and the lanthanum group metal.

In an embodiment, each of the first sub-layer, the second sub-layer, and the third sub-layer may include silver (Ag).

In an embodiment of the inventive concept, an electronic device includes a base layer, a circuit layer disposed on the base layer, and a display element layer disposed on the circuit layer and including a light-emitting element. The light-emitting element includes a first electrode, a functional layer disposed on the first electrode and including an emission layer, and a second electrode disposed on the functional layer. The second electrode includes a first layer disposed on the functional layer, a second layer disposed on the first layer and including a different material from that of the first layer, and a third layer disposed on the second layer and including a different material from that of the second layer. The second layer includes a plurality of sub-layers each including silver (Ag), and the plurality of sub-layers include a first sub-layer disposed on the first layer, a second sub-layer disposed on the first sub-layer, and a third sub-layer disposed on the second sub-layer. A film density of the second sub-layer is lower than a film density of each of the first sub-layer and the third sub-layer, and the film density of the first sub-layer and the film density of the third sub-layer are substantially the same.

In an embodiment of the inventive concept, a method for manufacturing a light-emitting element includes forming, on a first electrode, a functional layer including an emission layer, forming a second electrode on the functional layer, and forming a capping layer on the second electrode. The forming the second electrode includes forming a first layer on the functional layer, forming a second layer on the first layer by a different material from that of the first layer, and forming a third layer on the second layer by a different material from that of the second layer. The forming the second layer includes depositing silver (Ag) onto the first layer at a first deposition rate to form a first sub-layer, depositing silver (Ag) onto the first sub-layer at a second deposition rate to form a second sub-layer, and depositing silver (Ag) onto the second sub-layer at a third deposition rate to form a third sub-layer. The first deposition rate and the second deposition rate are different, and the second deposition rate and the third deposition rate are different.

In an embodiment, each of the forming the first sub-layer, the forming the second sub-layer, and the forming the third sub-layer may include a thermal evaporation process.

In an embodiment, the second deposition rate may be lower than each of the first deposition rate and the third deposition rate, and the first deposition rate and the third deposition rate may be substantially the same.

In an embodiment, the forming the second layer may further include depositing silver (Ag) onto the third sub-layer at a fourth deposition rate to form a fourth sub-layer, and depositing silver (Ag) onto the fourth sub-layer at a fifth deposition rate to form a fifth sub-layer. The third deposition rate and the fourth deposition rate may be different, and the fourth deposition rate and the fifth deposition rate may be different.

In an embodiment, in the forming the second electrode, the first layer may be directly formed on the functional layer, the second layer may be directly formed on the first layer, and the third layer may be directly formed on the second layer.

At least some of the above and other features of the invention are set out in the claims.

### BRIEF DESCRIPTION OF THE DRAWINGS

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1 is a perspective view of an embodiment of an electronic device according to the inventive concept;
FIG. 2 is a cross-sectional view of an embodiment of an electronic device according to the inventive concept;
FIG. 3 is a plan view of an embodiment of a display panel according to the inventive concept;
FIG. 4 is an enlarged plan view of an embodiment of a portion of a display panel according to the inventive concept;
FIG. 5 is a cross-sectional view of an embodiment of an electronic device according to the inventive concept;
FIG. 6 is a cross-sectional view of an embodiment of an electronic device according to the inventive concept;
FIGS. 7 to 9 are each a schematic cross-sectional view illustrating an embodiment of a light-emitting element;
FIGS. 10A to 10C are each a cross-sectional view of an embodiment of a second electrode;
FIGS. 11 to 14 are each a cross-sectional view of an embodiment of an electronic device;
FIGS. 15A to 15D are cross-sectional views of an embodiment of some operations of a method for manufacturing a light-emitting element; and
FIGS. 16A to 16C are cross-sectional views of an embodiment of some operations of a method for manufacturing a light-emitting element.

### DETAILED DESCRIPTION

The disclosure may be modified in various forms, and particular embodiments thereof will be illustrated in the drawings and described herein in detail. The inventive concept should not be construed as limited to the embodiments set forth herein. Rather, these embodiments are provided so that this disclosure will be thorough and complete, and will fully convey the scope of the inventive concept to those skilled in the art.

Like reference numbers or symbols refer to like elements in the drawings. In the drawings, the dimensions of structures are exaggerated for clarity of illustration. It will be understood that, although the terms "first", "second", etc. may be used herein to describe various elements, the elements are not to be limited by these terms. These terms are only used to distinguish one element from another element. For instance, a first element, component, region, layer or section discussed below could be termed a second element, component, region, layer or section without departing from the scope of the inventive concept. Similarly, a second element, component, region, layer or section could be termed a first element, component, region, layer or section. In this specification, the singular expressions "a", "an" and "the" are intended to include the plural forms as well, unless the context clearly indicates otherwise.

It will be further understood that the terms "comprises, includes, has" and/or "comprising, including, having", when used in this specification, specify the presence of stated features, numbers, steps, operations, elements, components or combinations thereof, but do not preclude the possibility of the presence or addition of one or more other features, numbers, steps, operations, elements, components, and/or combinations thereof.

It will also be understood that when a part such as a layer, film, region, or a plate, is also referred to as being "on" or "above" another part, it may be directly on a remaining (the other) part, or an intervening layer may also be present. In contrast, when an element such as a layer, film, region, or a plate, is also referred to as being "below" or "under" another part, it may be directly below a remaining (the other) element, or an intervening element may also be present. In addition, when an element is also referred to as being "on" another element, it may be disposed on the top or the bottom of a remaining (the other) element.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

Hereinafter, embodiments of the inventive concept will be described with reference to the accompanying drawings.

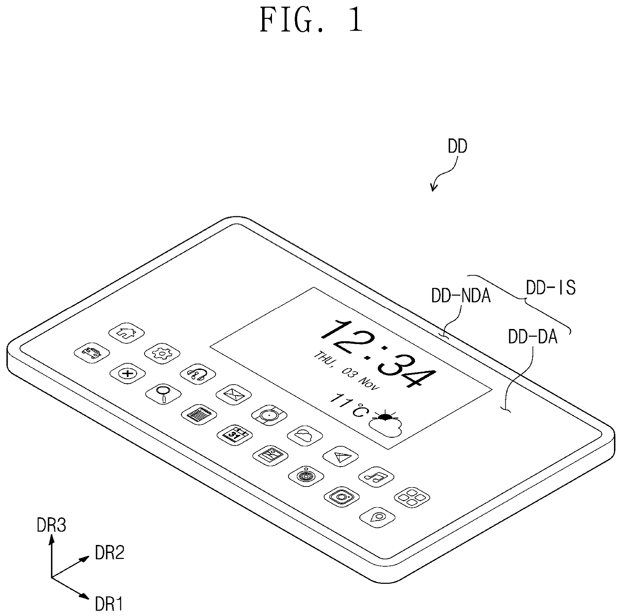

FIG. 1 is a perspective view of an embodiment of an electronic device DD according to the inventive concept. As illustrated in FIG. 1, the electronic device DD may display an image through a display surface DD-IS. The display surface DD-IS may have a quadrangular shape, e.g., rectangular shape having long sides extending in a first direction DR1 and short sides extending in a second direction DR2 crossing the first direction DR1 in a plan view. However, the display surface DD-IS is not limited thereto, and may have various shapes such as a circular shape and a polygonal shape.

In this embodiment, a third direction DR3 may be defined as a direction substantially perpendicular to a plane defined by the first direction DR1 and the second direction DR2. A front surface (or top surface) and a rear surface (or bottom surface) of each of the members, which constitute the electronic device DD, may oppose each other in the third direction DR3, and a normal direction to each of the front surface and the rear surface may be substantially parallel to the third direction DR3. A separation distance between the front surface and the rear surface, which is defined in the third direction DR3, may correspond to a thickness of the member.

The term "in a plan view" used herein may be defined as being in a state when viewed in the third direction DR3. That is, the term "in a plan view" may be described on the basis of a plane defined by the first direction DR1 and the second direction DR2 together. The term "in a cross-section" used herein may be defined as being in a state when viewed in the first direction DR1 or the second direction DR2. However, directions indicated by the first to third directions DR1, DR2 and DR3 are relative concepts and may be changed to other directions.

In an embodiment of the inventive concept, the electronic device DD is illustrated as including a planar display surface, but is not limited thereto. The electronic device DD may include a curved display surface or a three-dimensional display surface. The three-dimensional display surface may include a plurality of display areas oriented in different directions, and may include a bent display surface, for example. The electronic device DD in the illustrative embodiment may be a flexible electronic device DD. The flexible electronic device DD may be a foldable display device which is capable of folding.

In this embodiment, the electronic device DD which may be applied to a tablet terminal is illustrated as an example. Electronic modules, a camera module, a power module, or the like, which are disposed (e.g., mounted) on a main board, may be disposed in a bracket/case or the like together with the electronic device DD, thereby constituting the tablet terminal. The electronic device DD in an embodiment of the inventive concept may be applied to a large-sized electronic device such as a television or a monitor, and also to a relatively small and medium-sized electronic device such as a mobile phone, a vehicle navigation device, a game console, or a smart watch.

The electronic device DD in an embodiment may be a transparent display device. The transparent display device may display information in a state in which an object disposed on a rear surface of the electronic device DD looks transparent from a front surface of the electronic device DD. Thus, a user may recognize the object disposed on the rear surface of the electronic device DD from the front surface of the electronic device DD.

As illustrated in FIG. 1, the display surface DD-IS includes an image area DD-DA on which an image is displayed, and a bezel area DD-NDA next (adjacent) to the image area DD-DA. The bezel area DD-NDA is an area on which an image is not displayed. FIG. 1 illustrates icon images as one embodiment of the image.

As illustrated in FIG. 1, the image area DD-DA may have a substantially quadrangular shape, e.g., rectangular shape. The "substantially quadrangular shape, e.g., rectangular shape" includes not only a rectangular shape in terms of mathematics, but also a rectangular shape in which not a vertex but a curved boundary is defined on a vertex area (or corner area).

The bezel area DD-NDA may surround the image area DD-DA. However, the shape of the bezel area DD-NDA is not limited thereto and may be changed. In an embodiment, the bezel area DD-NDA may be disposed on only one side of the image area DD-DA, for example.

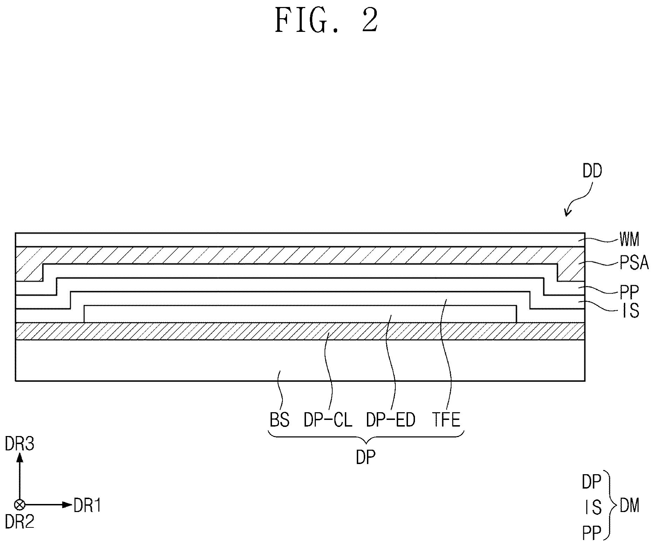

FIG. 2 is a cross-sectional view of an embodiment of an electronic device DD according to the inventive concept.

The electronic device DD may include a display module DM and a window WM disposed on the display module DM. The display module DM and the window WM may be coupled to each other through an adhesive layer PSA. In an embodiment of the inventive concept, the window WM may be formed by a coating method, and the window WM may contact the display module DM. Here, the adhesive layer PSA may be omitted.

The display module DM may include a display panel DP, an input sensor IS, and an optical layer PP. The display panel DP may include a base layer BS, a circuit layer DP-CL, a display element layer DP-ED, and an encapsulation layer TFE.

The circuit layer DP-CL is disposed on a top surface of the base layer BS. The base layer BS may be a flexible substrate capable of bending, folding, rolling or the like. The base layer BS may be a glass substrate, a metal substrate, a polymer substrate, or the like. However, the inventive concept is not limited thereto, and the base layer BS may be an inorganic layer, an organic layer, or a composite material layer. The base layer BS has substantially the same shape as that of the display panel DP.

The base layer BS may have a multilayer structure. In an embodiment, the base layer BS may include a first synthetic resin layer, a second synthetic resin layer, and inorganic layers disposed between the first and second synthetic resin layers, for example. Each of the first and second synthetic resin layers may include a polyimide-based resin, and is not particularly limited.

The circuit layer DP-CL may be disposed on the base layer BS. The circuit layer DP-CL may include a plurality of insulating layers, a plurality of semiconductor patterns, a plurality of conductive patterns, signal lines, or the like. The circuit layer DP-CL may include a driving circuit of a pixel.

The display element layer DP-ED may be disposed on the circuit layer DP-CL. The display element layer DP-ED may include a light-emitting element. In an embodiment, the light-emitting element may include an organic light-emitting material, an inorganic light-emitting material, an organic-inorganic light-emitting material, a quantum dot, a quantum rod, a micro light-emitting diode ("LED"), or a nano LED, for example.

The encapsulation layer TFE may be disposed on the display element layer DP-ED. The encapsulation layer TFE may protect the display element layer DP-ED, i.e., the light-emitting element, from moisture, oxygen, and foreign matter such as dust particles. The encapsulation layer TFE may include at least one inorganic encapsulation layer. The encapsulation layer TFE may include a stack structure of a first inorganic encapsulation layer/an organic encapsulation layer/a second inorganic encapsulation layer.

The input sensor IS may be directly disposed on the display panel DP. The input sensor IS may detect a user's input by an electromagnetic induction method and/or a capacitance method, for example. The display panel DP and the input sensor IS may be formed through a continuous process. Here, "being directly disposed" may mean that a third component is not disposed between the input sensor IS and the display panel DP. In an embodiment, a separate adhesive member may not be disposed between the input sensor IS and the display panel DP, for example. The input sensor IS may be omitted in the electronic device DD according to the inventive concept.

The optical layer PP reduces reflectance of external light incident from above the window WM. The optical layer PP in an embodiment of the inventive concept may include a retarder and a polarizer. The retarder may be a film type or a liquid crystal coating type, and may include a λ/2 retarder and/or a λ/4 retarder. The polarizer may also be a film type or a liquid crystal coating type. The film type may include a stretchable synthetic resin film, and the liquid crystal coating type may include liquid crystals arranged in a predetermined arrangement. The retarder and the polarizer may further include a protective film. The retarder and the polarizer themselves or the protective film may be defined as a base layer of the optical layer PP.

The optical layer PP in an embodiment of the inventive concept may include color filters. The color filters have a predetermined arrangement. The arrangement of the color filters may be determined in consideration of emissive colors of pixels included in the display panel DP. The optical layer PP may further include a black matrix next (adjacent) to the color filters. The optical layer PP including the color filters may be directly disposed on the display panel DP.

The window WM in an embodiment of the inventive concept may include a base layer and a light-blocking pattern. The base layer may include a glass substrate and/or a synthetic resin film, for example. The light-blocking pattern partially overlaps the base layer. The light-blocking pattern may be disposed on a rear surface of the base layer, and the light-blocking pattern may substantially define the bezel area DD-NDA (refer to FIG. 1) of the electronic device DD. An area in which the light-blocking pattern is not disposed may define the image area DD-DA (refer to FIG. 1) of the electronic device DD.

Although not illustrated, the electronic device DD in an embodiment may further include a housing which accommodates at least a portion of the display module DM. The housing may protect the display module DM against an external impact or penetration of foreign matter.

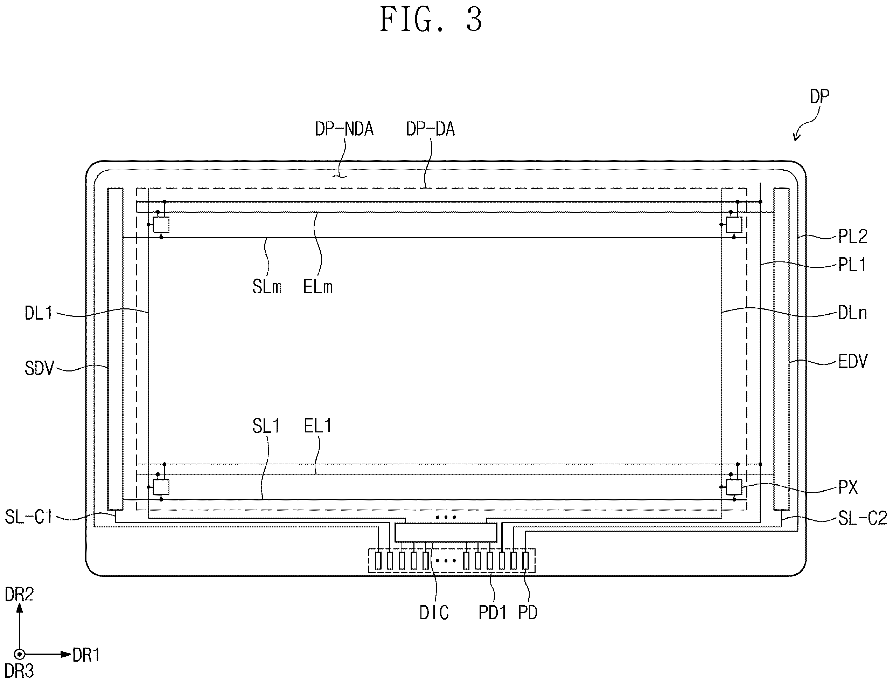

FIG. 3 is a plan view of an embodiment of a display panel DP according to the inventive concept.

Referring to FIG. 3, the display panel DP may include a plurality of pixels PX, a scan driving circuit SDV, an emission driving circuit EDV, a plurality of signal lines, and a plurality of pads PD. The plurality of pixels PX are disposed in a display area DP-DA. A driving chip DIC disposed (e.g., mounted) in a non-display area DP-NDA may include a data driving circuit. The display area DP-DA may correspond to the image area DD-DA in FIG. 1, and the non-display area DP-NDA may correspond to the bezel area DD-NDA in FIG. 1. In the disclosure, "an area or portion corresponding to another area or portion" means that the area or portion overlaps a remaining (the other) area or portion, and is not necessarily limited to the meaning that two different areas or portions have the same surface area. In an embodiment of the inventive concept, the data driving circuit may also be integrated into the display panel DP like the scan driving circuit SDV and the emission driving circuit EDV.

The plurality of signal lines may include a plurality of scan lines SL1 to SLm, a plurality of data lines DL1 to DLn, a plurality of emission lines EL1 to ELm, first and second control lines SL-C1 and SL-C2, and first and second power lines PL1 and PL2. Here, m and n are each a natural number of 2 or more.

The scan lines SL1 to SLm may extend in the first direction DR1 to be electrically connected to the pixels PX and the scan driving circuit SDV. The data lines DL1 to DLn may extend in the second direction DR2 to be electrically connected to the pixels PX and the driving chip DIC. The emission lines EL1 to ELm may extend in the first direction DR1 to be electrically connected to the pixels PX and the emission driving circuit EDV.

The first power line PL1 receives a first power voltage, and the second power line PL2 receives a second power voltage having a lower level than the first power voltage. Although not illustrated, a second electrode (e.g., a cathode) of a light-emitting element is connected to the second power line PL2.

The first control line SL-C1 may be connected to the scan driving circuit SDV and extend toward a lower end of the display panel DP. The second control line SL-C2 may be connected to the emission driving circuit EDV and extend toward the lower end of the display panel DP. The pads PD may be disposed in a pad area PD1 in the non-display area DP-NDA next (adjacent) to the lower end of the display panel DP, and be more next (adjacent) to the lower end of the display panel DP than the driving chip DIC is. The pads PD may be connected to the driving chip DIC and some of the signal lines.

The scan driving circuit SDV may generate a plurality of scan signals, and the scan signals may be applied to the pixels PX through the scan lines SL1 to SLm. The driving chip DIC may generate a plurality of data voltages, and the data voltages may be applied to the pixels PX through the data lines DL1 to DLn. The emission driving circuit EDV may generate a plurality of emission signals, and the emission signals may be applied to the pixels PX through the emission lines EL1 to ELm. The pixels PX may receive the data voltages in response to the scan signals. The pixels PX may display an image by emitting light with luminance corresponding to the data voltages in response to the emission signals.

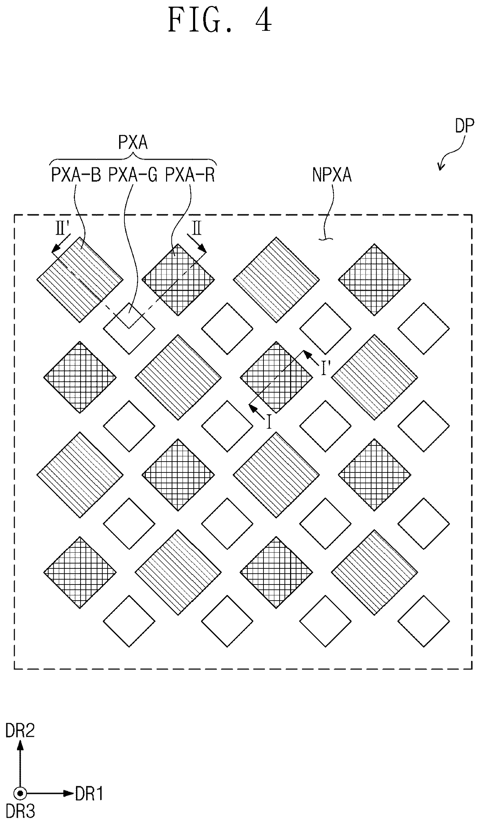

FIG. 4 is a plan view illustrating an embodiment of a display panel DP. The contents about the display panel DP as below may apply to the display panel DP included in the electronic device DD illustrated in FIGS. 1 and 2.

Referring to FIG. 4, the display panel DP may include an emission area PXA and a non-emission area NPXA. The non-emission area NPXA may surround the emission area PXA. The emission area PXA may be provided in plural. The emission area PXA may include a red emission area PXA-R, a green emission area PXA-G, and a blue emission area PXA-B. The red emission area PXA-R, the green emission area PXA-G, and the blue emission area PXA-B may emit light in different wavelength regions. The red emission area PXA-R may emit red light, the green emission area PXA-G may emit green light, and the blue emission area PXA-B may emit blue light.

Among the plurality of emission areas PXA-R, PXA-G and PXA-B, the blue emission area PXA-B may have the largest surface area, and the green emission area PXA-G may have the smallest surface area. However, this is illustrative, and the surface areas of the plurality of emission areas PXA-R, PXA-G and PXA-B are not limited thereto. FIG. 4 illustrates the red emission area PXA-R and the blue emission area PXA-B which are alternately arranged in one row, and the green emission area PXA-G which is arranged in another row so as to be spaced apart from the red emission area PXA-R and the blue emission area PXA-B. However, this is illustrative, and the arrangement of the plurality of emission areas PXA-R, PXA-G and PXA-B is not limited thereto. In an embodiment, the emission areas PXA-R, PXA-G and PXA-B may be arranged in the form of stripes, for example. In an alternative embodiment, the emission areas PXA-R, PXA-G and PXA-B may have a PenTile (PENTILE^{™}) arrangement shape or a diamond (Diamond Pixel^{™}) arrangement shape.

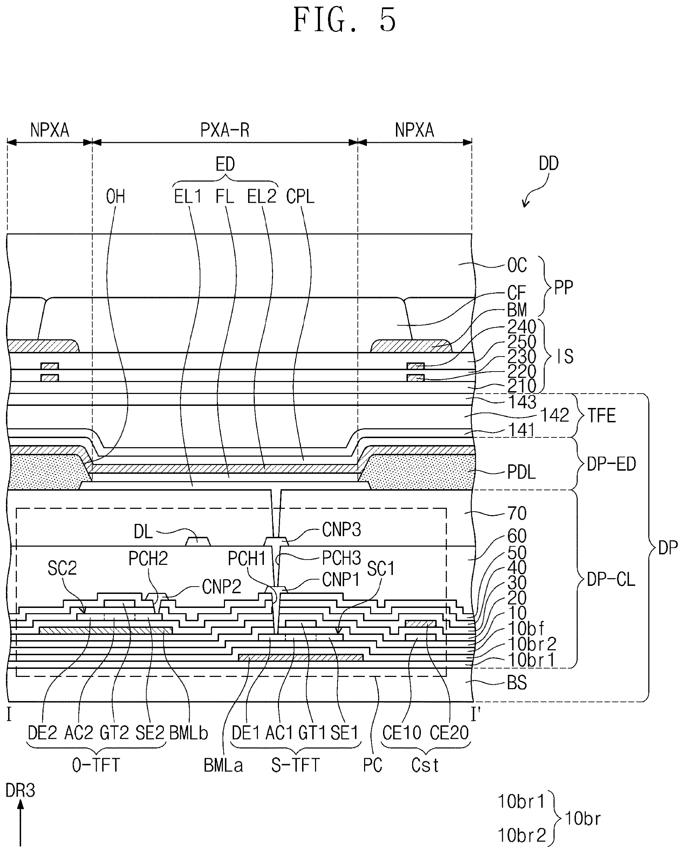

FIG. 5 is a cross-sectional view of an embodiment of an electronic device DD according to the inventive concept. FIG. 5 illustrates a cross-section of the electronic device DD corresponding to line I-I' in FIG. 4. Some components of the electronic device DD, e.g., the adhesive layer PSA and the window WM in FIG. 2, are not illustrated in FIG. 5.

A pixel driving circuit PC which drives a light-emitting element ED may include a plurality of pixel driving elements. The pixel driving circuit PC may include a plurality of transistors S-TFT and O-TFT and a capacitor Cst. In an embodiment of the transistors, FIG. 5 illustrates a silicon transistor S-TFT and an oxide transistor O-TFT. However, the pixel driving circuit PC in FIG. 5 is just an illustrative embodiment, and the components of the pixel driving circuit PC are not necessarily limited thereto. The pixel driving circuit PC may include only one type of a transistor among the silicon transistor S-TFT and the oxide transistor O-TFT.

Referring to FIG. 5, a base layer BS is illustrated as a single layer. The base layer BS may include a synthetic resin such as polyimide. A synthetic resin layer may be applied onto a work substrate (or a carrier substrate) to form the base layer BS. When a follow-up process is performed to complete the electronic device DD, the work substrate may be removed. In an embodiment of the inventive concept, the base layer BS may have a multilayer structure including a first synthetic resin layer, at least one inorganic layer, and a second synthetic resin layer.

Referring to FIG. 5, a barrier layer 10br may be disposed on the base layer BS. The barrier layer 10br prevents foreign matter from being introduced from the outside. The barrier layer 10br may include at least one inorganic layer. The barrier layer 10br may include a silicon oxide layer and a silicon nitride layer. Each of the silicon oxide layer and the silicon nitride layer may be provided in plural, and the silicon oxide layers and the silicon nitride layers may be alternately stacked.

The barrier layer 10br may include a lower barrier layer 10br1 and an upper barrier layer 10br2. A first shielding electrode BMLa may be disposed between the lower barrier layer 10br1 and the upper barrier layer 10br2. The first shielding electrode BMLa may be arranged to correspond to the silicon transistor S-TFT. The first shielding electrode BMLa may include a metal, e.g., molybdenum.

The first shielding electrode BMLa may receive a bias voltage. The first shielding electrode BMLa may receive a first power voltage. The first shielding electrode (also referred to as a first shielding pattern) BMLa may prevent an electrical potential due to a polarization phenomenon from affecting the silicon transistor S-TFT. The first shielding pattern BMLa may prevent external light from reaching the silicon transistor S-TFT. In an embodiment of the inventive concept, the first shielding pattern BMLa may be a floating electrode having a shape isolated from another electrode or line.

A buffer layer 10bf may be disposed on the barrier layer 10br. The buffer layer 10bf may prevent a phenomenon in which metal atoms or impurities are spread from the base layer BS to a first semiconductor pattern SC1 above the buffer layer 10bf. The buffer layer 10bf may include at least one inorganic layer. The buffer layer 10bf may include a silicon oxide layer and a silicon nitride layer.

The first semiconductor pattern SC1 may be disposed on the buffer layer 10bf. The first semiconductor pattern SC1 may include a silicon semiconductor. In an embodiment, the silicon semiconductor may include an amorphous silicon, a polycrystalline silicon, or the like, for example. In an embodiment, the first semiconductor pattern SC1 may include a low-temperature polysilicon, for example.

The first semiconductor pattern SC1 may have different electrical properties according to doping. The first semiconductor pattern SC1 may include a first region with relatively high conductivity and a second region with relatively low conductivity. The first region may be doped with an n-type dopant or a p-type dopant. The second region may be a non-doped region, or a region doped at a lower concentration than the first region. A source region SE1, a channel region AC1 (or an active region), and a drain region DE1 of the silicon transistor S-TFT may be provided from the first semiconductor pattern SC1. The source region SE1 and the drain region DE1 may extend from the channel region AC1 in opposite directions in a cross-section.

A first insulating layer 10 may be disposed on the buffer layer 10bf. The first insulating layer 10 may cover the first semiconductor pattern SC1. The first insulating layer 10 may be an inorganic layer. The first insulating layer 10 may be a silicon oxide layer having a single-layer structure. Not only the first insulating layer 10 but also an inorganic layer of a driving element layer 120 to be described later may each have a single-layer structure or a multilayer structure, and may include at least one of the materials described above. However, the inventive concept is not limited thereto.

A gate GT1 of the silicon transistor S-TFT is disposed on the first insulating layer 10. The gate GT1 may be a portion of a metal pattern. The gate GT1 overlaps the channel region AC1. The gate GT1 may serve as a mask in a process of doping the first semiconductor pattern SC1. A first electrode CE10 of a storage capacitor Cst is disposed on the first insulating layer 10. Unlike an embodiment illustrated in FIG. 5, the first electrode CE10 may have a shape of a single body together with the gate GT1.

A second insulating layer 20 may be disposed on the first insulating layer 10 and cover the gate GT1. In an embodiment of the inventive concept, an upper electrode overlapping the gate GT1 may be further disposed on the second insulating layer 20. A second electrode CE20 of the storage capacitor Cst overlapping the first electrode CE10 may be disposed on the second insulating layer 20. The upper electrode may have a shape of a single body together with the second electrode CE20 in a plan view.

A second shielding electrode BMLb is disposed on the second insulating layer 20. The second shielding electrode BMLb may be arranged to correspond to the oxide transistor O-TFT. In an embodiment of the inventive concept, the second shielding electrode BMLb may be omitted. In an embodiment of the inventive concept, the first shielding electrode BMLa may extend to below the oxide transistor O-TFT and replace the second shielding electrode BMLb.

A third insulating layer 30 may be disposed on the second insulating layer 20. A second semiconductor pattern SC2 may be disposed on the third insulating layer 30. The second semiconductor pattern SC2 may include a channel region AC2 of the oxide transistor O-TFT. The second semiconductor pattern SC2 may include a metal oxide semiconductor. The second semiconductor pattern SC2 may include a transparent conductive oxide ("TCO") such as ITO, IZO, indium gallium zinc oxide ("IGZO"), zinc oxide (ZnOₓ), or indium oxide (In₂O₃).

The metal oxide semiconductor may include a plurality of regions SE2, AC2 and DE2 divided according to whether the transparent conductive oxide is reduced or not. A region in which the transparent conductive oxide is reduced (hereinafter referred to as a reduction region), has higher conductivity than a region in which the transparent conductive oxide is not reduced (hereinafter referred to as a non-reduction region). The reduction region substantially serves as a source/drain or a signal line of a transistor. The non-reduction region substantially corresponds to a semiconductor region (or channel) of the transistor. A fourth insulating layer 40 may be disposed on the third insulating layer 30. As illustrated in FIG. 5, the fourth insulating layer 40 may cover the second semiconductor pattern SC2. In an alternative embodiment of the inventive concept, the fourth insulating layer 40 may be an insulating pattern which overlaps a gate GT2 of the oxide transistor O-TFT and exposes a source region SE2 and a drain region DE2 of the oxide transistor O-TFT.

The gate GT2 of the oxide transistor O-TFT is disposed on the fourth insulating layer 40. The gate GT2 of the oxide transistor O-TFT may be a portion of a metal pattern. The gate GT2 of the oxide transistor O-TFT overlaps the channel region AC2. A fifth insulating layer 50 may be disposed on the fourth insulating layer 40, and the fifth insulating layer 50 may cover the gate GT2. Each of the first insulating layer 10 to the fifth insulating layer 50 may be an inorganic layer.

A first connection pattern CNP1 and a second connection pattern CNP2 may be disposed on the fifth insulating layer 50. The first connection pattern CNP1 and the second connection pattern CNP2 may be formed through the same process, and thus have the same material and the same stack structure. The first connection pattern CNP1 may be connected to the drain region DE1 of the silicon transistor S-TFT through a first pixel contact hole PCH1 passing through the first to fifth insulating layers 10, 20, 30, 40 and 50. The second connection pattern CNP2 may be connected to the source region SE2 of the oxide transistor O-TFT through a second pixel contact hole PCH2 passing through the fourth and fifth insulating layers 40 and 50. The connection relationships of the first connection pattern CNP1 and the second connection pattern CNP2 with respect to the silicon transistor S-TFT and the oxide transistor O-TFT are not necessarily limited thereto.

A sixth insulating layer 60 may be disposed on the fifth insulating layer 50. A third connection pattern CNP3 may be disposed on the sixth insulating layer 60. The third connection pattern CNP3 may be connected to the first connection pattern CNP1 through a third pixel contact hole PCH3 passing through the sixth insulating layer 60. A data line DL may be disposed on the sixth insulating layer 60. A seventh insulating layer 70 may be disposed on the sixth insulating layer 60, and cover the third connection pattern CNP3 and the data line DL. The third connection pattern CNP3 and the data line DL may be formed through the same process, and thus have the same material and the same stack structure. Each of the sixth insulating layer 60 and the seventh insulating layer 70 may be an organic layer.

The light-emitting element ED includes a first electrode EL1, a functional layer FL, and a second electrode EL2. The first electrode EL1 of the light-emitting element ED may be disposed on the seventh insulating layer 70. The first electrode EL1 may be a (semi-)transmissive electrode or a reflective electrode. The first electrode EL1 may include a stack structure of ITO/Ag/ITO stacked in sequence. Respective positions of the first electrode EL1 and the second electrode EL2 may be exchanged.

A pixel defining film PDL may be disposed on the seventh insulating layer 70. The pixel defining film PDL may be an organic layer. The pixel defining film PDL may have a light-absorbing property, and for example, the pixel defining film PDL may have a black color. The pixel defining film PDL may include a black component (black coloring agent). The black component may include a black dye or a black pigment. The black component may include a carbon black, a metal such as chrome, or an oxide thereof. The pixel defining film PDL may correspond to a light-blocking pattern having a light-blocking characteristic.

The pixel defining film PDL may cover a portion of the first electrode EL1. In an embodiment, an opening portion OH which exposes a portion of the first electrode EL1 may be defined in the pixel defining film PDL, for example. An emission area PXA-R may be defined to correspond to the opening portion OH. FIG. 5 illustrates one emission area PXA-R corresponding to the red emission area PXA-R in FIG. 4. The cross-section corresponding to the green emission area PXA-G and the blue emission area PXA-B in FIG. 4 may also be substantially the same as the cross-section illustrated in FIG. 5. However, functional layers FL including different materials from the functional layer FL in the red emission area PXA-R may be disposed in the green emission area PXA-G and the blue emission area PXA-B.

In an embodiment of the inventive concept, the functional layer FL includes at least an emission layer. In addition to the emission layer, the functional layer FL may further include a charge control layer described as a hole transport region, an electron transport region, or the like. This will be described later.

The light-emitting element ED in an embodiment further includes a capping layer CPL. The capping layer CPL may be disposed on the second electrode EL2 and provided to improve efficiency of extraction of light generated from the emission layer of the light-emitting element ED.

An encapsulation layer TFE may cover the light-emitting element ED. The encapsulation layer TFE may include a first inorganic encapsulation layer 141, an organic encapsulation layer 142, and a second inorganic encapsulation layer 143 which are stacked in sequence, but the layers constituting the encapsulation layer TFE are not necessarily limited thereto. The inorganic encapsulation layers 141 and 143 may include a silicon nitride layer, a silicon oxynitride layer, a silicon oxide layer, a titanium oxide layer, an aluminium oxide layer, or the like. The inorganic encapsulation layers 141 and 143 may each have a multilayer structure. The organic encapsulation layer 142 may include an acrylic organic layer or an epoxy-based organic layer, and is not limited thereto. The organic encapsulation layer 142 may include a photopolymerizable organic material. The first inorganic encapsulation layer 141 may be directly disposed on the capping layer CPL of the light-emitting element ED.

An input sensor IS includes a plurality of conductive patterns. The input sensor IS may include at least one conductive layer (or at least one sensor conductive layer) including the plurality of conductive patterns and at least one insulating layer (or at least one sensor insulating layer). In this embodiment, the input sensor IS may include a first insulating layer 210 (or a first sensor insulating layer), a first conductive layer 220 (or a first sensor conductive layer), a second insulating layer 230 (or a second sensor insulating layer), a second conductive layer 240 (or a second sensor conductive layer), and a third insulating layer 250 (or a third sensor insulating layer). FIG. 5 schematically illustrates the plurality of conductive patterns included in each of the first conductive layer 220 and the second conductive layer 240.

The first insulating layer 210 may be directly disposed on a display panel DP. The first insulating layer 210 may be an inorganic layer including at least one of silicon nitride, silicon oxynitride, or silicon oxide. Each of the first conductive layer 220 and the second conductive layer 240 may have a single-layer structure, or have a multilayer structure in which layers are stacked in the third direction DR3. The first conductive layer 220 and the second conductive layer 240 may include conductive lines that define a mesh-shaped electrode. According to positions, the conductive line of the first conductive layer 220 and the conductive line of the second conductive layer 240 may be connected to each other through a contact hole passing through the second insulating layer 230 or may not be connected.

The first conductive layer 220 and the second conductive layer 240 each having a single-layer structure may include a metal layer or a transparent conductive layer. The metal layer may include molybdenum, silver, titanium, copper, aluminium, or any alloys thereof. The transparent conductive layer may include a transparent conductive oxide such as ITO, IZO, zinc oxide (ZnOₓ), or indium zinc tin oxide ("IZTO"). In addition, the transparent conductive layer may include a conductive polymer such as poly(3,4-ethylenedioxythiophene) ("PEDOT"), metal nanowire, graphene, or the like.

The first conductive layer 220 and the second conductive layer 240 each having a multilayer structure may include metal layers. The metal layers may have a three-layer structure of titanium/aluminium/titanium, for example. The conductive layer having a multilayer structure may include at least one metal layer and at least one transparent conductive layer. The second insulating layer 230 may be disposed between the first conductive layer 220 and the second conductive layer 240. The second insulating layer 230 disposed between the first conductive layer 220 and the second conductive layer 240 may be described as a "sensing insulating layer" herein. The third insulating layer 250 may cover the second conductive layer 240. In an embodiment of the inventive concept, the third insulating layer 250 may be omitted. The second insulating layer 230 and the third insulating layer 250 may include an inorganic layer or an organic layer.

An optical layer PP may be disposed on the input sensor IS. The optical layer PP may include a light-blocking pattern BM, a color filter CF, and a planarization layer OC.

A material constituting the light-blocking pattern BM is not particularly limited as long as it is a material that absorbs light. The light-blocking pattern BM may be a layer having a black color, and in an embodiment, the light-blocking pattern BM may include a black component (black coloring agent). The black component may include a black dye or a black pigment. The black component may include a carbon black, a metal such as chromium, or an oxide thereof.

The light-blocking pattern BM may overlap the first conductive layer 220 and the second conductive layer 240 in a plan view. The light-blocking pattern BM may prevent reflection of external light by the first conductive layer 220 and the second conductive layer 240. The light-blocking pattern BM may overlap a non-emission area NPXA.

The color filter CF may overlap at least the emission area PXA-R. A portion of the color filter CF may overlap the non-emission area NPXA. A portion of the color filter CF may be disposed on the light-blocking pattern BM. The color filter CF may transmit the light generated by the light-emitting element ED, and block some wavelength bands of the external light. The color filter CF may prevent reflection of external light by the first electrode EL1 and the second electrode EL2.

The planarization layer OC may cover the light-blocking pattern BM and the color filter CF. The planarization layer OC may include an organic material, and the planarization layer OC may provide a flat top surface.

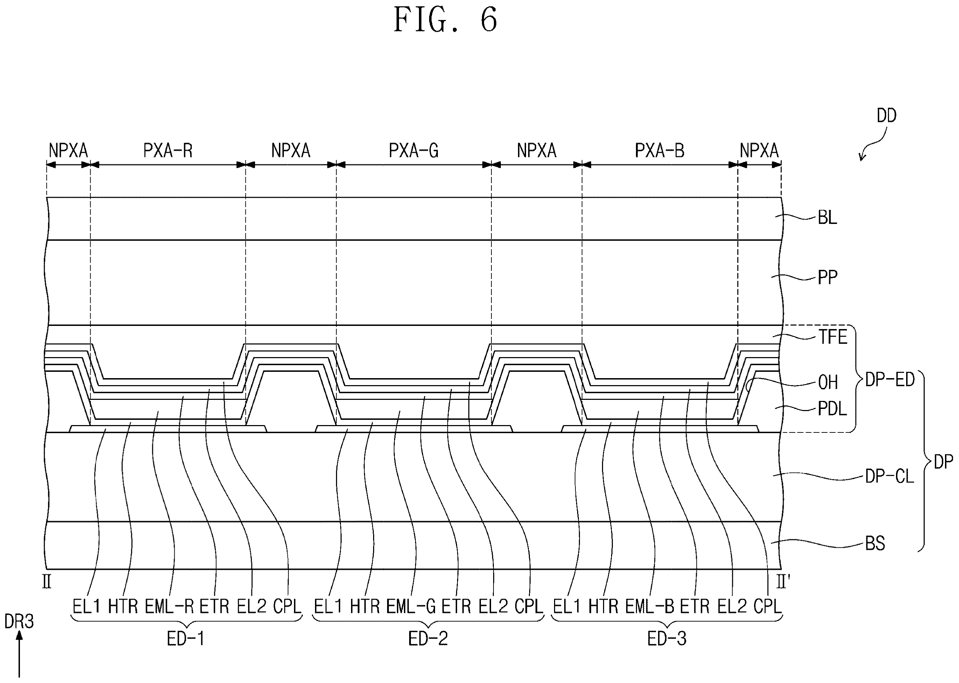

FIG. 6 is a cross-sectional view of an embodiment of an electronic device DD. FIG. 6 is a cross-sectional view illustrating a portion corresponding to line II-II' in FIG. 4. Some components of the electronic device DD, e.g., the input sensor IS, the adhesive layer PSA, and the window WM in FIG. 2, are not illustrated in FIG. 6.

The electronic device DD may include a display panel DP, and an optical layer PP disposed on the display panel DP. The display panel DP includes light-emitting elements ED-1, ED-2 and ED-3. The electronic device DD may include the plurality of light-emitting elements ED-1, ED-2 and ED-3. The optical layer PP may be disposed on the display panel DP and control reflected light from the display panel DP due to external light. The optical layer PP may include a polarizing layer or a color filter layer, for example. However, unlike an embodiment illustrated in the drawing, the optical layer PP may be omitted in the electronic device DD.

A base substrate BL may be disposed on the optical layer PP. The base substrate BL may be a member that provides a base surface on which the optical layer PP is disposed. The base substrate BL may be a glass substrate, a metal substrate, a plastic substrate, or the like. However, the disclosure is not limited thereto, and the base substrate BL may be an inorganic layer, an organic layer, or a composite material layer. In an alternative embodiment, unlike the illustrated embodiment, the base substrate BL may be omitted in an embodiment.

The electronic device DD in an embodiment may further include a filling layer (not illustrated). The filling layer (not illustrated) may be disposed between a display element layer DP-ED and the base substrate BL. The filling layer (not illustrated) may be an organic material layer. The filling layer (not illustrated) may include at least one of an acrylic resin, a silicone-based resin, or an epoxy-based resin.

The display panel DP may include a base layer BS, and a circuit layer DP-CL and the display element layer DP-ED which are provided on the base layer BS. The display element layer DP-ED may include pixel defining films PDL, the light-emitting elements ED-1, ED-2 and ED-3, each of which is disposed between the pixel defining films PDL, and an encapsulation layer TFE disposed on the light-emitting elements ED-1, ED-2 and ED-3.

The base layer BS may be a member that provides a base surface on which the display element layer DP-ED is disposed. The base layer BS may be a glass substrate, a metal substrate, a plastic substrate, or the like. However, the disclosure is not limited thereto, and the base layer BS may be an inorganic layer, an organic layer, or a composite material layer.

In an embodiment, the circuit layer DP-CL may be disposed on the base layer BS, and the circuit layer DP-CL may include a plurality of transistors (not illustrated). The transistors (not illustrated) may each include a control electrode, an input electrode, and an output electrode. In an embodiment, the circuit layer DP-CL may include a switching transistor and a driving transistor each for driving the light-emitting elements ED-1, ED-2 and ED-3 of the display element layer DP-ED, for example.

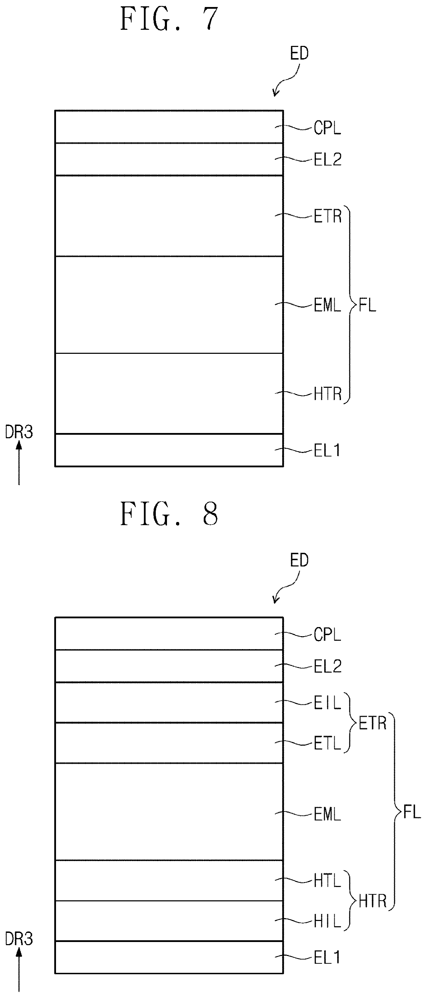

Each of the light-emitting elements ED-1, ED-2 and ED-3 may have a structure of a light-emitting element ED in an embodiment in FIGS. 7 to 9, which will be described later. The light-emitting elements ED-1, ED-2 and ED-3 may each include a first electrode EL1, a hole transport region HTR, an emission layer EML-R, EML-G or EML-B, an electron transport region ETR, a second electrode EL2, and a capping layer CPL.

FIG. 6 illustrates an embodiment in which the emission layers EML-R, EML-G and EML-B of the light-emitting elements ED-1, ED-2 and ED-3 are disposed in opening portions OH defined in the pixel defining films PDL, and the hole transport region HTR, the electron transport region ETR, and the second electrode EL2 are each provided as a common layer over the entirety of the light-emitting elements ED-1, ED-2 and ED-3. However, the disclosure is not limited thereto, and unlike an embodiment illustrated in FIG. 6, in an embodiment, the hole transport region HTR and the electron transport region ETR may be patterned inside the opening portions OH defined in the pixel defining films PDL. In an embodiment, the hole transport region HTR, the emission layers EML-R, EML-G and EML-B, and the electron transport region ETR of the light-emitting elements ED-1, ED-2 and ED-3 may be patterned in an inkjet printing method, for example.

The encapsulation layer TFE may cover the light-emitting elements ED-1, ED-2 and ED-3. The encapsulation layer TFE may seal the display element layer DP-ED. The encapsulation layer TFE may be a thin-film encapsulation layer. The encapsulation layer TFE may have a single-layer structure or a structure in which a plurality of layers are stacked. The encapsulation layer TFE includes at least one insulating layer. The encapsulation layer TFE may include the first inorganic encapsulation layer 141 (refer to FIG. 5), the organic encapsulation layer 142 (refer to FIG. 5), and the second inorganic encapsulation layer 143 (refer to FIG. 5). The first inorganic encapsulation layer 141 (refer to FIG. 5) may be directly disposed on the capping layer CPL of each of the light-emitting elements ED-1, ED-2 and ED-3.

The encapsulation layer TFE may be disposed on the second electrode EL2 and arranged to fill the opening portions OH.

Referring to FIGS. 4 and 6, the electronic device DD may include non-emission areas NPXA and emission areas PXA-R, PXA-G and PXA-B. Each of the emission areas PXA-R, PXA-G and PXA-B may be an area from which light generated from each of the light-emitting elements ED-1, ED-2 and ED-3 is emitted. The emission areas PXA-R, PXA-G and PXA-B may be spaced apart from each other in a plan view.

The emission areas PXA-R, PXA-G and PXA-B may be areas divided by a pixel defining film PDL. Each of the non-emission areas NPXA may be an area between neighboring emission areas of the emission areas PXA-R, PXA-G and PXA-B, and an area corresponding to the pixel defining film PDL. In the disclosure, each of the emission areas PXA-R, PXA-G and PXA-B may correspond to a pixel. The pixel defining film PDL may divide the light-emitting elements ED-1, ED-2 and ED-3. The emission layers EML-R, EML-G and EML-B of the light-emitting elements ED-1, ED-2 and ED-3 may be divided as being disposed in the opening portions OH defined in the pixel defining film PDL.

The emission areas PXA-R, PXA-G and PXA-B may be divided into a plurality of groups according to colors of light generated from the light-emitting elements ED-1, ED-2 and ED-3. In the electronic device DD in an embodiment illustrated in FIGS. 1 and 2, three emission areas PXA-R, PXA-G and PXA-B which emit red light, green light, and blue light are illustrated as an example. In an embodiment, the electronic device DD in an embodiment may include a red emission area PXA-R, a green emission area PXA-G, and a blue emission area PXA-B which are distinguished from each other, for example.

In the electronic device DD in an embodiment, the plurality of light-emitting elements ED-1, ED-2 and ED-3 may emit light having different wavelength regions from each other. In an embodiment, the electronic device DD may include a first light-emitting element ED-1 which emits the red light, a second light-emitting element ED-2 which emits the green light, and a third light-emitting element ED-3 which emits the blue light, for example. That is, the red emission area PXA-R, the green emission area PXA-G, and the blue emission area PXA-B of the electronic device DD may correspond to the first light-emitting element ED-1, the second light-emitting element ED-2, and the third light-emitting element ED-3, respectively.

However, the disclosure is not limited thereto, and the first to third light-emitting elements ED-1, ED-2 and ED-3 may emit light in the same wavelength region, or at least one thereof may emit light in a different wavelength region. In an embodiment, all of the first to third light-emitting elements ED-1, ED-2 and ED-3 may emit the blue light, for example.

Hereinafter, FIGS. 7 to 9 are each a schematic cross-sectional view illustrating an embodiment of a light-emitting element.

A light-emitting element ED in an embodiment includes a first electrode EL1, a second electrode EL2 facing the first electrode EL1, and at least one functional layer FL disposed between the first electrode EL1 and the second electrode EL2. The light-emitting element ED further includes a capping layer CPL disposed on the second electrode EL2.

As illustrated in FIG. 7, the light-emitting element ED may include, as the at least one functional layer FL, a hole transport region HTR, an emission layer EML, an electron transport region ETR, or the like which are stacked in sequence. That is, the light-emitting element ED in an embodiment may include the first electrode EL1, the hole transport region HTR, the emission layer EML, the electron transport region ETR, and the second electrode EL2 which are stacked in sequence. The light-emitting element ED may include the capping layer CPL disposed on the second electrode EL2.

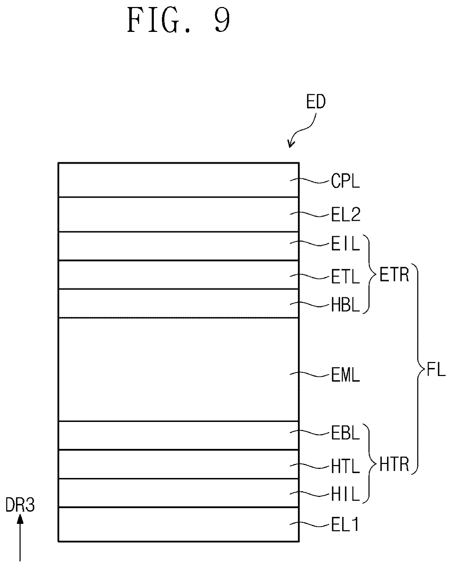

Compared to FIG. 7, FIG. 8 illustrates a cross-section of a light-emitting element ED in an embodiment in which a hole transport region HTR includes a hole injection layer HIL and a hole transport layer HTL, and an electron transport region ETR includes an electron injection layer EIL and an electron transport layer ETL. In addition, compared to FIG. 7, FIG. 9 illustrates a cross-section of a light-emitting element ED in an embodiment in which a hole transport region HTR includes a hole injection layer HIL, a hole transport layer HTL, and an electron blocking layer EBL, and an electron transport region ETR includes an electron injection layer EIL, an electron transport layer ETL, and a hole blocking layer HBL.

The first electrode EL1 has conductivity. The first electrode EL1 may include a metal material, a metal alloy, or a conductive compound. The first electrode EL1 may be an anode or a cathode. However, the disclosure is not limited thereto. In addition, the first electrode EL1 may be a pixel electrode. The first electrode EL1 may be a transmissive electrode, a semi-transmissive electrode, or a reflective electrode. The first electrode EL1 may include at least one selected from Ag, Mg, Cu, Al, Pt, Pd, Au, Ni, Nd, Ir, Cr, Li, Ca, LiF, Mo, Ti, W, In, Sn, and Zn, a compound of two or more selected from the foregoing materials, any combinations of two or more selected from the foregoing materials, or an oxide of the foregoing material.

When the first electrode EL1 is a transmissive electrode, the first electrode EL1 may include a transparent metal oxide, e.g., indium tin oxide ("ITO"), indium zinc oxide ("IZO"), zinc oxide (ZnO), indium tin zinc oxide ("ITZO"), or the like. When the first electrode EL1 is a semi-transmissive electrode or a reflective electrode, the first electrode EL1 may include Ag, Mg, Cu, Al, Pt, Pd, Au, Ni, Nd, Ir, Cr, Li, Ca, LiF/Ca (a stack structure of LiF and Ca), LiF/Al (a stack structure of LiF and Al), Mo, Ti, W, or any compounds or combinations thereof (e.g., a combination of Ag and Mg). In an alternative embodiment, the first electrode EL1 may have a multilayer structure including a reflective film or a semi-transmissive film, each of which includes the foregoing material, and a transparent conductive film including ITO, IZO, zinc oxide (ZnO), ITZO or the like. In an embodiment, the first electrode EL1 may have a three-layer structure of ITO/Ag/ITO, for example, but is not limited thereto. In addition, the disclosure is not limited thereto, and the first electrode EL1 may include the foregoing metal material, any combinations of two or more metal materials selected from the foregoing metal materials, an oxide of the foregoing metal materials, or the like. The first electrode EL1 may have a thickness of about 700 angstroms (Å) to about 10,000 Å. In an embodiment, the thickness of the first electrode EL1 may be about 1,000 Å to about 3,000 Å, for example.

The hole transport region HTR is provided on the first electrode EL1. The hole transport region HTR may include at least one of the hole injection layer HIL, the hole transport layer HTL, a buffer layer or emission auxiliary layer (not illustrated), or the electron blocking layer EBL. The hole transport region HTR may have a thickness of about 50 Å to about 15,000 Å, for example.

The hole transport region HTR may have a single layer including a single material, or a single layer including a plurality of different materials, or a multilayer structure having a plurality of layers including a plurality of different materials from each other.

In an embodiment, the hole transport region HTR may have a single-layer structure of the hole injection layer HIL or the hole transport layer HTL, or a single-layer structure including a hole injection material and a hole transport material, for example. In an alternative embodiment, the hole transport region HTR may have a single-layer structure including a plurality of different materials, or a structure in which the hole injection layer HIL/hole transport layer HTL, the hole injection layer HIL/hole transport layer HTL/buffer layer (not illustrated), the hole injection layer HIL/buffer layer (not illustrated), the hole transport layer HTL/buffer layer (not illustrated), or the hole injection layer HIL/hole transport layer HTL/electron blocking layer EBL are stacked in sequence on the first electrode EL1. However, the disclosure is not limited thereto.

The hole transport region HTR may be formed using various methods such as a vacuum deposition method, a spin coating method, a cast method, a Langmuir-Blodgett ("LB") method, an inkjet printing method, a laser printing method, or a laser induced thermal imaging ("LITI") method.

The hole transport region HTR may include a compound represented by any one of compounds of Compound Group H below. However, the compounds listed in Compound Group H below are examples, and the compound included in the hole transport region HTR is not limited to the compounds listed in Compound Group H below.

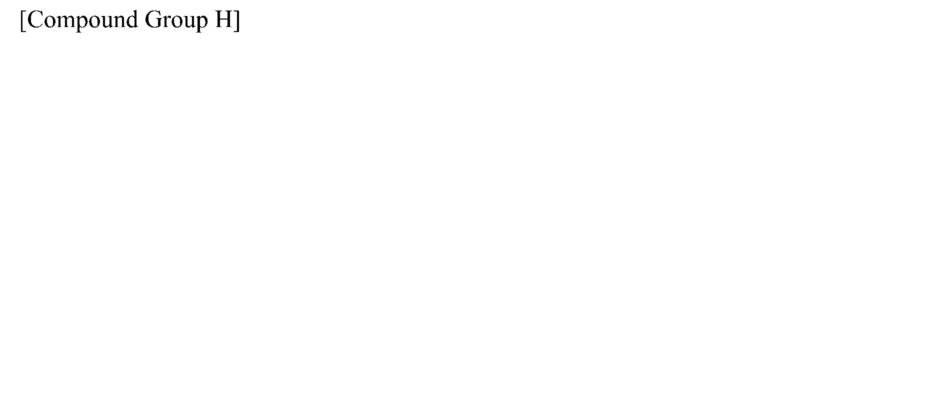

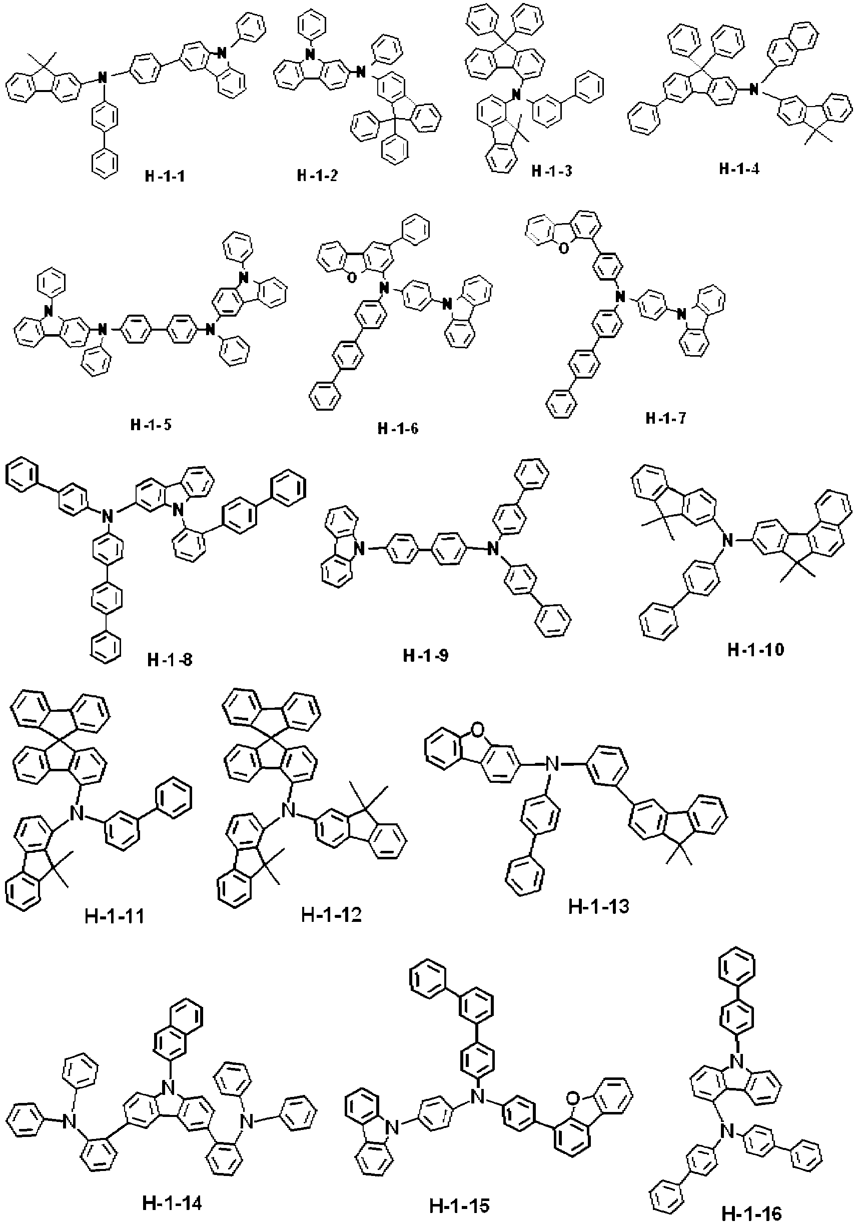

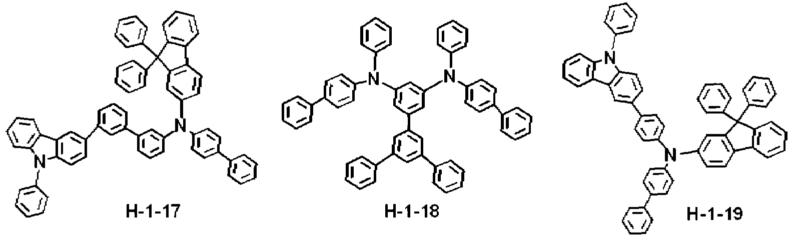

The hole transport region HTR may include a phthalocyanine compound such as copper phthalocyanine, N¹,N¹'-([1,1'-biphenyl]-4,4'-diyl)bis(N¹-phenyl-N⁴,N⁴-di-m-tolylbenzene-1,4-diamine) ("DNTPD"), 4,4',4"-[tris(3-methylphenyl)phenylamino] triphenylamine ("m-MTDATA"), (4,4'4"-Tris(N,N-diphenylamino)triphenylamine ("TDATA"), 4,4',4"-tris[N(2-naphthyl)-N-phenylamino]-triphenylamine ("2-TNATA"), Poly(3,4-ethylenedioxythiophene)/Poly(4-styrenesulfonate) ("PEDOT/PSS"), Polyaniline/Dodecylbenzenesulfonic acid ("PANI/DBSA"), Polyaniline/Camphor sulfonicacid ("PANI/CSA"), Polyaniline/Poly(4-styrenesulfonate) ("PANI/PSS"), N,N'-di(naphthalene-1-yl)-N,N'-diphenyl-benzidine ("NPB"), triphenylamine-containing polyetherketone ("TPAPEK"), 4-Isopropyl-4'-methyldiphenyliodonium [Tetrakis(pentafluorophenyl)borate], dipyrazino[2,3-f: 2',3'-h] quinoxaline-2,3,6,7,10,11-hexacarbonitrile ("HATCN"), or the like.

The hole transport region HTR may include a carbazole-based derivative such as N-phenyl carbazole or polyvinyl carbazole, a fluorene-based derivative, a triphenylamine-based derivative such as N,N'-bis(3-methylphenyl)-N,N'-diphenyl-[1,1'-biphenyl]-4,4'-diamine ("TPD") or 4,4',4"-tris(N-carbazolyl)triphenylamine ("TCTA"), NPB, 4,4'-Cyclohexylidene bis[N,N-bis(4-methylphenyl)benzenamine] ("TAPC"), 4,4'-Bis[N,N'-(3-tolyl)amino]-3,3'-dimethylbiphenyl ("HMTPD"), 1,3-Bis(N-carbazolyl)benzene ("mCP"), or the like.

In an alternative embodiment, the hole transport region HTR may include 9-(4-tert-Butylphenyl)-3,6-bis(triphenylsilyl)-9H-carbazole ("CzSi"), 9-phenyl-9H-3,9'-bicarbazole ("CCP"), 1,3-bis(1,8-dimethyl-9H-carbazol-9-yl)benzene ("mDCP"), or the like.

In the hole transport region HTR, the foregoing compounds of the hole transport region may be included in at least one of the hole injection layer HIL, the hole transport layer HTL, or the electron blocking layer EBL.

The hole transport region HTR may have a thickness of about 100 Å to about 10,000 Å, e.g., about 100 Å to about 5,000 Å. In a case in which the hole transport region HTR includes the hole injection layer HIL, the hole injection layer HIL may have a thickness of about 30Å to about 1,000Å, for example. In a case in which the hole transport region HTR includes the hole transport layer HTL, the hole transport layer HTL may have a thickness of about 30Å to about 1,000Å, for example. In an embodiment, in a case in which the hole transport region HTR includes the electron blocking layer EBL, the electron blocking layer EBL may have a thickness of about 10Å to about 1,000Å, for example. When the thicknesses of the hole transport region HTR, the hole injection layer HIL, the hole transport layer HTL, and the electron blocking layer EBL satisfy the foregoing ranges, satisfactory hole transport properties may be obtained without a substantial increase in driving voltage.

The hole transport region HTR may further include, in addition to the foregoing material, a charge generation material to improve conductivity. The charge generation material may be uniformly or non-uniformly dispersed in the hole transport region HTR. The charge generation material may be a p-type dopant, for example. The p-type dopant may include at least one of halogenated metal compounds, quinone derivatives, metal oxides, or cyano group-containing compounds, but is not limited thereto. In an embodiment, the p-type dopant may include halogenated metal compounds such as CuI and RbI, quinone derivatives such as tetracyanoquinodimethane ("TCNQ") and 2,3,5,6-tetrafluoro-7,7'8,8-tetracyanoquinodimethane ("F4-TCNQ"), metal oxides such as tungsten oxide and molybdenum oxide, cyano group-containing compounds such as HATCN and 4-[[2,3-bis[cyano-(4-cyano-2,3,5,6-tetrafluorophenyl)methylidene]cyclopropylidene]-cyanomethyl]-2,3,5,6-tetrafluorobenzonitrile ("NDP9"), or the like, for example, but the disclosure is not limited thereto.

As described above, the hole transport region HTR may further include at least one of the buffer layer (not illustrated) or the electron blocking layer EBL, in addition to the hole injection layer HIL and the hole transport layer HTL. The buffer layer (not illustrated) may compensate for a resonance distance according to wavelengths of light emitted from the emission layer EML and increase light emission efficiency. The material which may be included in the hole transport region HTR may be used as a material included in the buffer layer (not illustrated). The electron blocking layer EBL is a layer serving to prevent electrons from being injected from the electron transport region ETR to the hole transport region HTR.

The emission layer EML is provided on the hole transport region HTR. The emission layer EML may have a thickness of about 100 Å to about 1,000 Å, or about 100 Å to about 300 Å, for example. The emission layer EML may have a single layer including a single material, or a single layer including a plurality of different materials, or a multilayer structure having a plurality of layers including a plurality of different materials from each other.

In the light-emitting element ED in an embodiment, the emission layer EML may emit blue light. In an alternative embodiment, the emission layer EML may emit green light or red light.

In the light-emitting element ED in an embodiment, the emission layer EML may include an anthracene derivative, a pyrene derivative, a fluoranthene derivative, a chrysene derivative, a dihydrobenzanthracene derivative, or a triphenylene derivative. Specifically, the emission layer EML may include an anthracene derivative or a pyrene derivative.

In the light-emitting element ED in an embodiment illustrated in FIGS. 7 to 9, the emission layer EML may include general hosts and dopants. A fluorescent host included in the emission layer EML may be represented by any one of Compounds E1 to E19 below, for example.

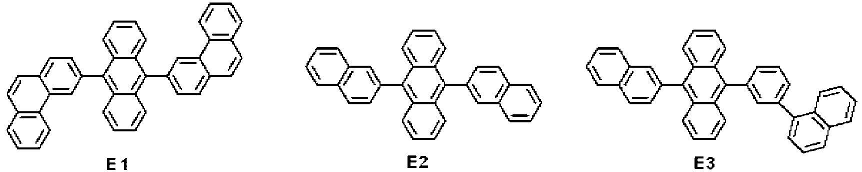

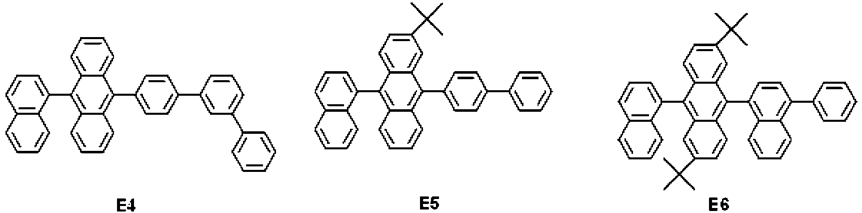

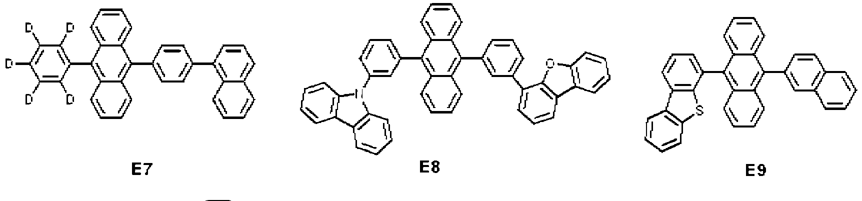

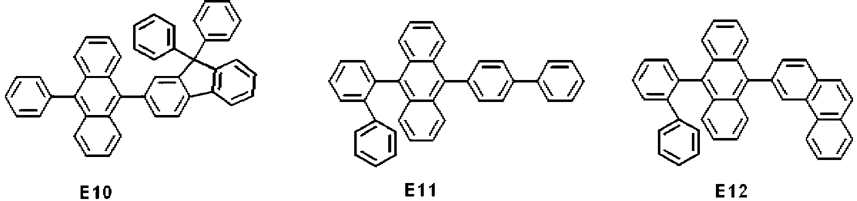

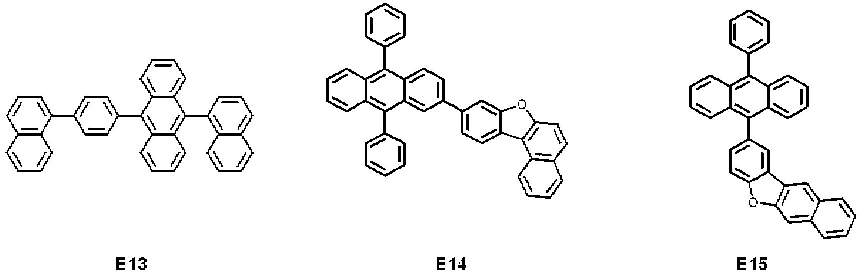

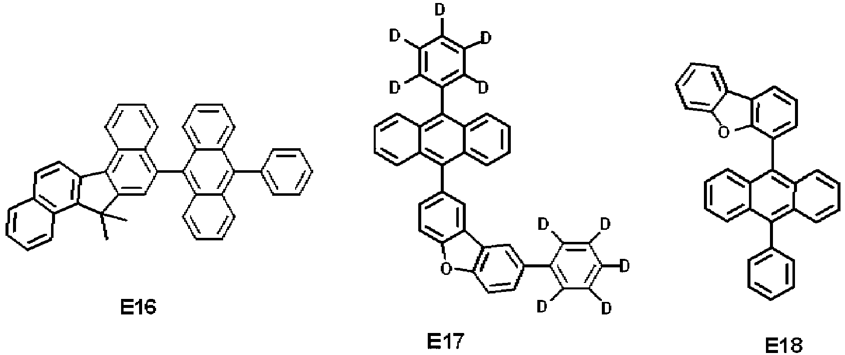

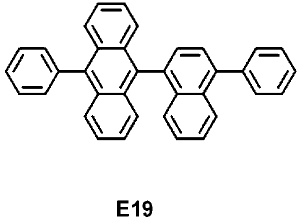

A phosphorescent host included in the emission layer EML may be represented by any one of compounds in Compound Group E-2 below, for example. However, the compounds listed in Compound Group E-2 below are examples, and a host compound included in the emission layer EML is not limited to the compounds listed in Compound Group E-2 below.

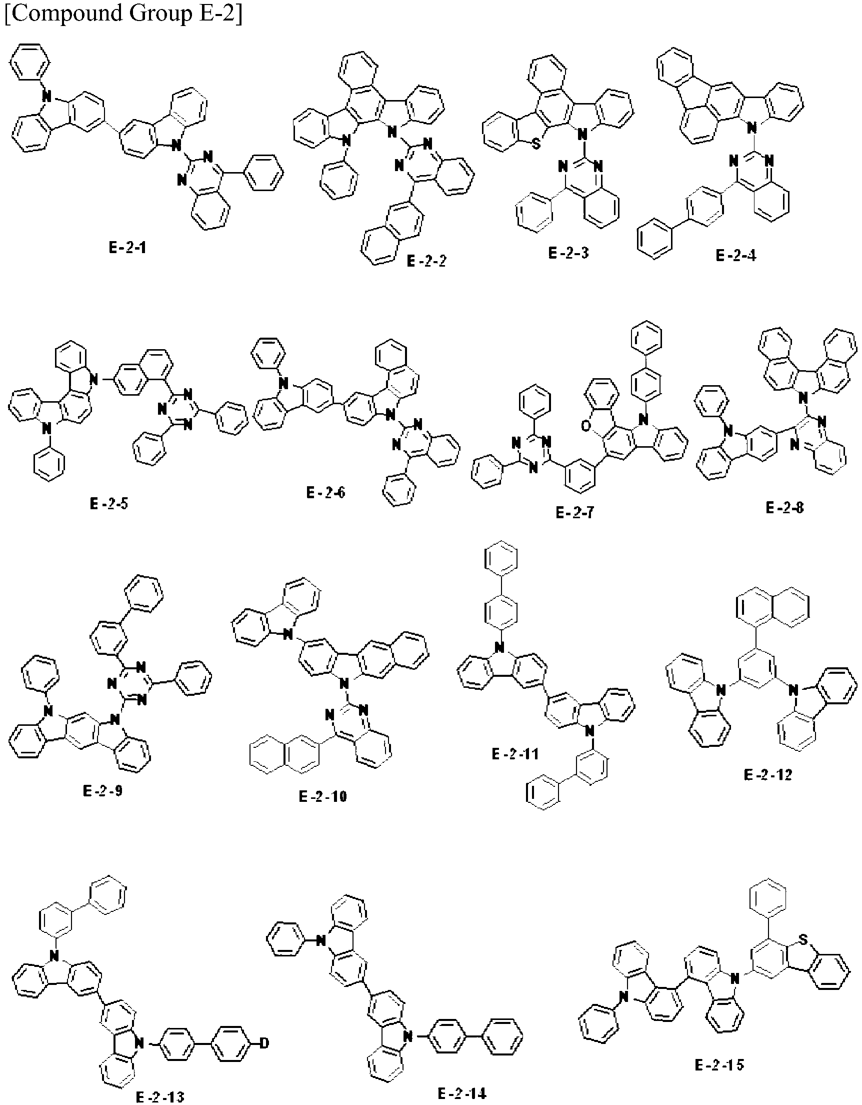

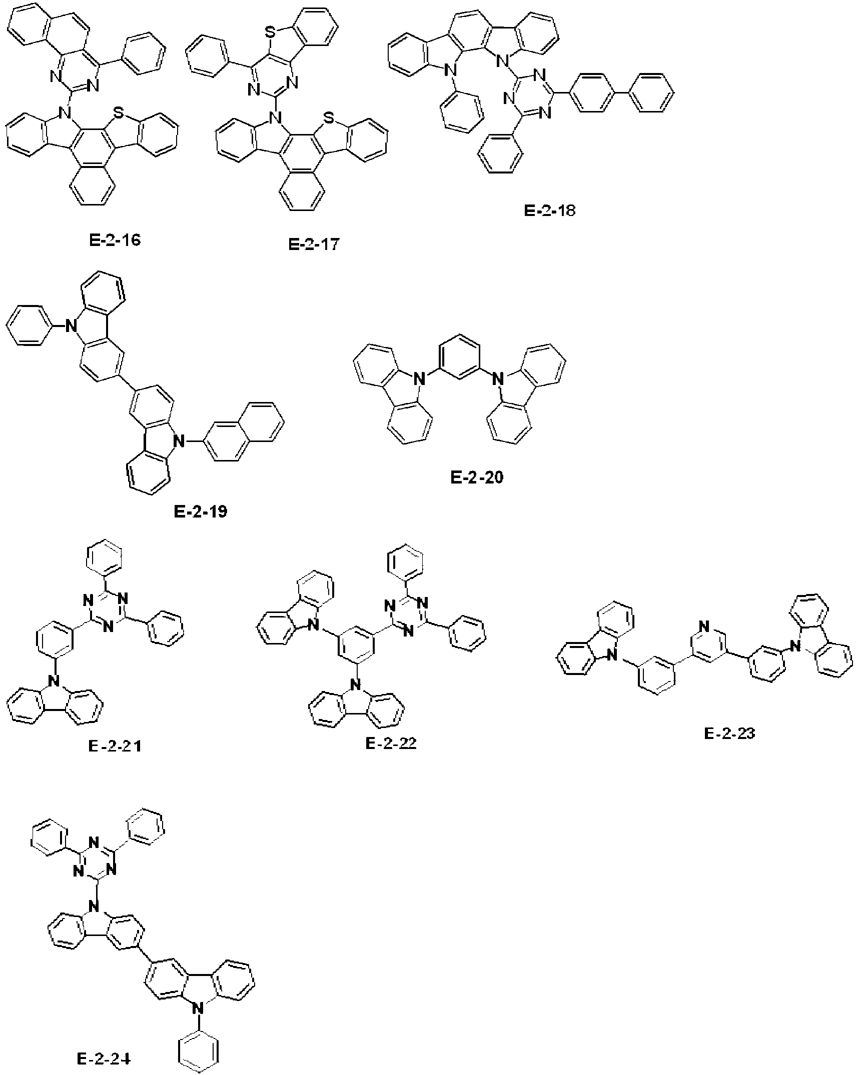

The emission layer EML may further include, as the host material, a general material known in this technical field. In an embodiment, the emission layer EML may include, as the host material, at least one of bis (4-(9H-carbazol-9-yl) phenyl) diphenylsilane ("BCPDS"), (4-(1-(4-(diphenylamino) phenyl) cyclohexyl) phenyl) diphenyl-phosphine oxide ("POPCPA"), Bis[2-(diphenylphosphino)phenyl] ether oxide ("DPEPO"), 4,4'-bis(N-carbazolyl)-1,1'-biphenyl ("CBP"), mCP, 2,8-Bis(diphenylphosphoryl)dibenzo[b,d]furan ("PPF"), 4,4',4"-Tris(carbazol-9-yl)-triphenylamine ("TCTA"), or 1,3,5-tris(1-phenyl-1H-benzo[d]imidazole-2-yl)benzene ("TPBi"), for example. However, the inventive concept is not limited thereto, and for example, tris(8-hydroxyquinolino)aluminium ("Alq₃"), 9,10-di(naphthalene-2-yl)anthracene ("ADN"), 2-tert-butyl-9,10-di(naphth-2-yl)anthracene ("TBADN"), distyrylarylene ("DSA"), 4,4'-bis(9-carbazolyl)-2,2'-dimethyl-biphenyl ("CDBP"), 2-Methyl-9,10-bis(naphthalen-2-yl)anthracene ("MADN"), Hexaphenyl cyclotriphosphazene ("CP1"), 1,4-Bis(triphenylsilyl)benzene ("UGH2"), Hexaphenylcyclotrisiloxane ("DPSiO₃"), Octaphenylcyclotetra siloxane ("DPSiO₄"), or the like, may be used as the host material.

The emission layer EML may include a phosphorescent dopant material represented by any one of Compounds M-a1 to M-a25 below. However, Compounds M-al to M-a25 below are examples, and the phosphorescent dopant material included in the emission layer EML is not limited to compounds represented by Compounds Ma1 to M-a25 below.

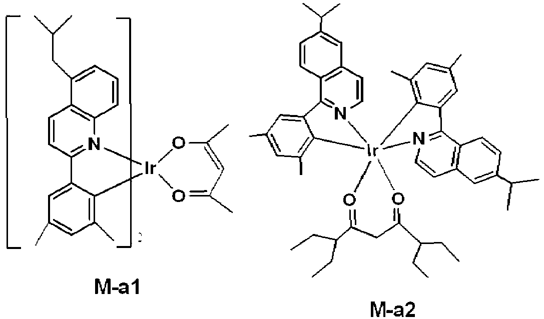

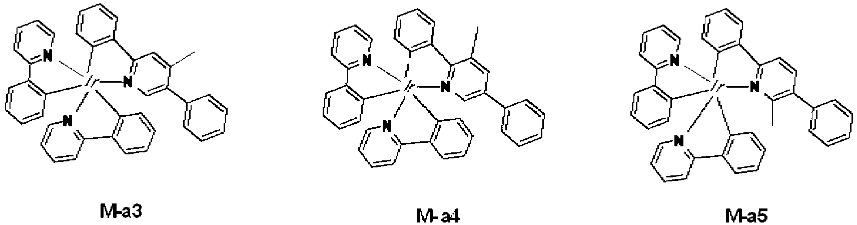

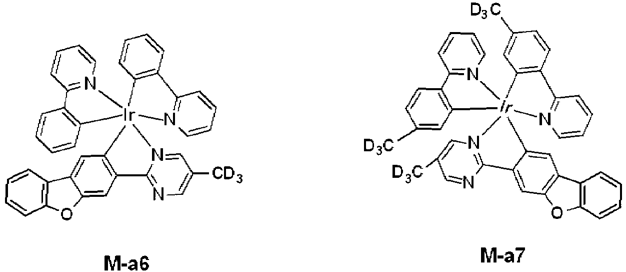

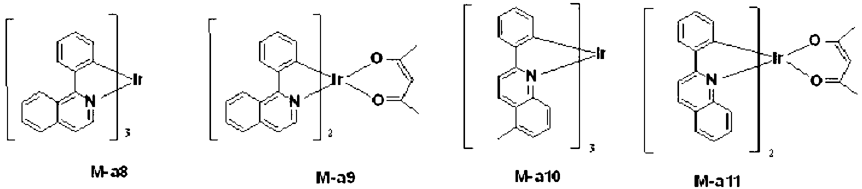

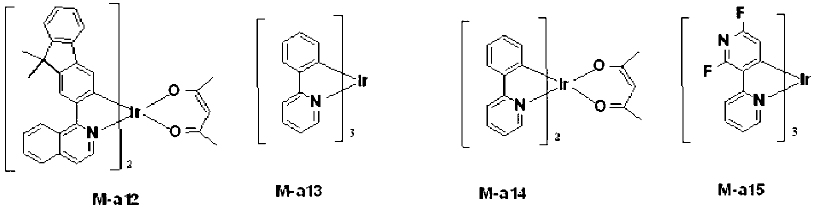

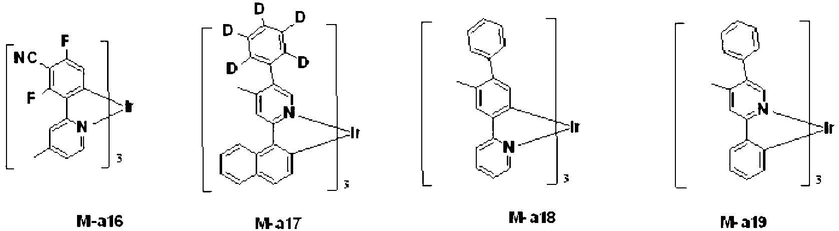

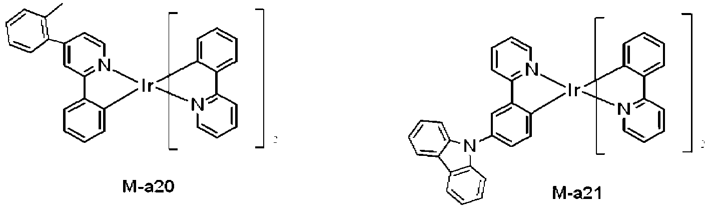

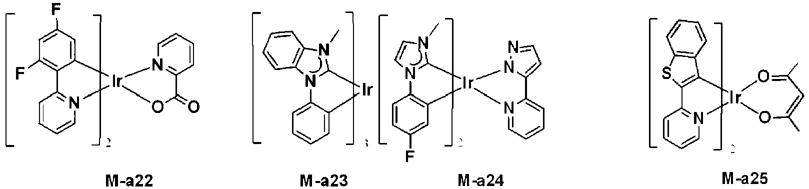

In an embodiment, the emission layer EML may further include, as a general dopant material, a styryl derivative (e.g., 1,4-bis[2-(3-N-ethylcarbazoryl)vinyl]benzene ("BCzVB"), 4-(di-p-tolylamino)-4'-[(di-p-tolylamino)styryl]stilbene ("DPAVB"), N-(4-((E)-2-(6-((E)-4-(diphenylamino)styryl)naphthalen-2-yl)vinyl)phenyl)-N-phenylbenzenamine ("N-BDAVBi")), 4,4'-bis[2-(4-(N,N-diphenylamino)phenyl)vinyl]biphenyl ("DPAVBi"), perylene and a derivative thereof (e.g., 2,5,8,11-Tetra-t-butylperylene ("TBP")), pyrene and a derivative thereof (e.g., 1,1-dipyrene, 1,4-dipyrenylbenzene, or 1, 4-Bis(N,N-Diphenylamino)pyrene), or the like.

The emission layer EML may further include a general phosphorescent dopant material. In an embodiment, a metal complex including iridium (Ir), platinum (Pt), osmium (Os), gold (Au), titanium (Ti), zirconium (Zr), hafnium (Hf), europium (Eu), terbium (Tb), or thulium (Tm) may be used as a phosphorescent dopant, for example. Specifically, iridium(III) bis(4,6-difluorophenylpyridinato-N,C2')picolinate ("FIrpic"), Bis(2,4-difluorophenylpyridinato)-tetrakis(1-pyrazolyl)borate iridium(III) ("Fir6"), or platinum octaethyl porphyrin ("PtOEP") may be used as the phosphorescent dopant. However, the disclosure is not limited thereto.

The emission layer EML may include a quantum dot.

The quantum dot used herein refers to a crystal of a semiconductor compound. The quantum dot may emit light in various emission wavelengths according to the size of the crystal. The quantum dot may emit light in various emission wavelengths by adjusting a ratio of elements in a quantum dot compound.

The quantum dot may have a diameter of about 1 nanometer (nm) to about 10 nm, for example.

The quantum dot may be synthesized through a wet chemical process, an organic metal chemical vapor deposition process, a molecular beam epitaxy process, or a similar process.

The wet chemical process is a method of mixing an organic solvent and a precursor material and then growing quantum dot particle crystals. When the crystals grow, the organic solvent may naturally serve as a dispersant coordinated on surfaces of the quantum dot crystals, and adjust the growth of the crystals. Thus, in the wet chemical process, the growth of quantum dot particles may be controlled through a process performed more easily and at lower costs than a vapor deposition process such as metal organic chemical vapor deposition ("MOCVD") or molecular beam epitaxy ("MBE").

The emission layer EML in an embodiment of the inventive concept may include a quantum dot material. A core of the quantum dot may be selected from a Group II-VI compound, a Group III-V compound, a Group III-VI compound, a Group I-III-VI compound, a Group IV-VI compound, a Group IV element, a Group IV compound, or any combinations thereof.

The Group II-VI compound may be selected from the group consisting of a binary compound selected from the group consisting of CdSe, CdTe, CdS, ZnS, ZnSe, ZnTe, ZnO, HgS, HgSe, HgTe, MgSe, MgS, and any combinations thereof, a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and any combinations thereof, and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and any combinations thereof. A Group II-VI semiconductor compound may further include a Group I metal and/or a Group IV element. The Group I-II-VI compound may include or consist of CuSnS or CuZnS, and the Group II-IV-VI compound may include or consist of ZnSnS, or the like. The Group I-II-IV-VI compound may include or consist of a quaternary compound selected from the group consisting of Cu₂ZnSnS₂, Cu₂ZnSnS₄, Cu₂ZnSnSe₄, Ag₂ZnSnS₂, and any combinations thereof.

The Group III-VI compound may include a binary compound such as In₂S₃ or In₂Se₃, a ternary compound such as InGaS₃ or InGaSe₃, or any combinations thereof.

The Group I-III-VI compound may include or consist of a ternary compound selected from the group consisting of AgInS, AgInS₂, CuInS, CuInS₂, AgGaS₂, CuGaS₂, CuGaO₂, AgGaO₂, AgAlO₂, and any combinations thereof, or a quaternary compound such as AgInGaS₂ or CuInGaS₂.

The Group III-V compound may be selected from the group consisting of a binary compound selected from the group consisting of GaN, GaP, GaAs, GaSb, AlN, AlP, AlAs, AlSb, InN, InP, InAs, InSb, and any combinations thereof, a ternary compound selected from the group consisting of GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and any combinations thereof, and a quaternary compound selected from the group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and any combinations thereof. The Group III-V compound may further include a Group II metal. In an embodiment, a Group III-II-V compound may include or consist of InZnP or the like, for example.

The Group IV-VI compound may be selected from the group consisting of a binary compound selected from the group consisting of SnS, SnSe, SnTe, PbS, PbSe, PbTe, and any combinations thereof, a ternary compound selected from the group consisting of SnSeS, SnSeTe, SnSTe, PbSeS, PbSeTe, PbSTe, SnPbS, SnPbSe, SnPbTe, and any combinations thereof, and a quaternary compound selected from the group consisting of SnPbSSe, SnPbSeTe, SnPbSTe, and any combinations thereof.

In embodiments, the Group II-IV-V semiconductor compound may include a ternary compound selected from the group consisting of ZnSnP, ZnSnP₂, ZnSnAs₂, ZnGeP₂, ZnGeAs₂, CdSnP₂, and any combinations thereof.

The Group IV element may be selected from the group consisting of Si, Ge, and any combinations thereof. The Group IV compound may be a binary compound selected from the group consisting of SiC, SiGe, and any combinations thereof.

Each of elements included in a multi-element compound such as the binary compound, the ternary compound, and the quaternary compound, may be in a particle at a uniform concentration or non-uniform concentration. That is, the foregoing formula indicates types of the elements included in the compound, and ratios of the elements in the compound may be different. In an embodiment, AgInGaS₂ may mean AgInₓGa₁₋ₓS₂ (x is a real number of 0 to 1), for example.

Here, the binary compound, the ternary compound, or the quaternary compound may be at a uniform concentration in a particle, or may be divided in partially different concentration distributions and in the same particle. In addition, the compound may have a core/shell structure in which one quantum dot surrounds another quantum dot. In the core/shell structure, the compound may have a concentration gradient in which the concentration of elements in the shell gradually decreases toward the core.

In some embodiments, the quantum dot may have the foregoing core/shell structure including a core having a nanocrystal and a shell surrounding the core. The shell of the quantum dot may serve as a protective layer for preventing a chemical change of the core to maintain semiconductor characteristics, and/or serve as a charging layer for imparting electrophoretic characteristics to the quantum dot. The shell may have a single-layer structure or a multilayer structure. In embodiments, the shell of the quantum dot may include a metal or nonmetal oxide, a semiconductor compound, or any combinations thereof.

In an embodiment, the metal or nonmetal oxide may include a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO, or a ternary compound such as MgAl₂O₄, CoFe₂O₄, NiFe₂O₄, or CoMn₂O₄, for example, but the inventive concept is not limited thereto.

In addition, embodiments of the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or the like, but the inventive concept is not limited thereto.

The quantum dot may have a full width of half maximum ("FWHM") of an emission wavelength spectrum of about 45 nm or less, preferably about 40 nm or less, more preferably about 30 nm or less, and, in this range, color purity or color reproducibility may be improved. Moreover, light emitted through this quantum dot may be emitted in all directions, thereby improving a wide viewing angle.

In addition, the form of the quantum dot is a form generally used in this field, and is not particularly limited. More specifically, spherical, pyramidal, multi-armed, or cubic nanoparticles, particles in the form of nanotubes, nanowires, nanofibers, or nanoplate, or the like, may be used.

In the quantum dot, an energy band gap may be adjusted by adjusting the size of the quantum dot or adjusting the ratio of elements in the quantum dot compound, and thus light having various wavelength bands may be obtained in a quantum dot emission layer. Thus, the quantum dots (having different sizes or having different ratios of elements in the quantum dot compound) as described above may be used to achieve a light-emitting element that emits light having several wavelengths. Specifically, the size of the quantum dot or the ratio of the elements in the quantum dot compound may be selectively adjusted so that red, green and/or blue light is emitted. In addition, the quantum dots may be provided to emit white light by combining light of various colors.

In the light-emitting element ED in an embodiment illustrated in FIGS. 7 to 9, the electron transport region ETR is provided on the emission layer EML. The electron transport region ETR may include at least one of the hole blocking layer HBL, the electron transport layer ETL, or the electron injection layer EIL, but the disclosure is not limited thereto.

The electron transport region ETR may have a single layer including a single material, or a single layer including a plurality of different materials, or a multilayer structure having a plurality of layers including a plurality of different materials from each other.

In an embodiment, the electron transport region ETR may have a single-layer structure of the electron injection layer EIL or the electron transport layer ETL, or may have a single-layer structure including an electron injection material or an electron transport material, for example. In an alternative embodiment, the electron transport region ETR may have a single-layer structure including a plurality of different materials, or have a structure in which the electron transport layer ETL/electron injection layer EIL, or the hole blocking layer HBL/electron transport layer ETL/electron injection layer EIL are stacked in sequence on the emission layer EML. However, the disclosure is not limited thereto. The electron transport region ETR may have a thickness of about 1,000 Å to about 1,500 Å, for example.

The electron transport region ETR may be formed using various methods such as a vacuum deposition method, a spin coating method, a cast method, an LB method, an inkjet printing method, a laser printing method, or an LITI method.

The electron transport region ETR may include an anthracene-based compound. However, the inventive concept is not limited thereto, and the electron transport region ETR may include Alq₃, 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazol-1-yl)phenyl)-9,10-dinaphthylanthracene, TPBi, 2,9-Dimethyl-4,7-diphenyl-1,10-phenanthroline ("BCP"), 4,7-Diphenyl-1,10-phenanthroline ("Bphen"), 3-(4-Biphenylyl)-4-phenyl-5-tert-butylphenyl-1,2,4-triazole ("TAZ"), 4-(Naphthalen-1-yl)-3,5-diphenyl-4H-1,2,4-triazole ("NTAZ"), 2-(4-Biphenylyl)-5-(4-tert-butylphenyl)-1,3,4-oxadiazole ("tBu-PBD"), Bis(2-methyl-8-quinolinolato-N1,O8)-(1,1'-Biphenyl-4-olato)aluminium ("BAlq"), berylliumbis(benzoquinolin-10-olate) ("Bebq₂"), ADN, 1,3-Bis[3,5-di(pyridin-3-yl)phenyl]benzene ("BmPyPhB"), 4'-(4-(4-(4,6-diphenyl-1,3,5-triazin-2-yl)phenyl)naphthalen-1-yl)-[1,1'-biphenyl]-4-carbonitrile ("CNNPTRZ"), and any combinations thereof, for example.

The electron transport region ETR may include at least one of Compounds ET1 to ET36 below.

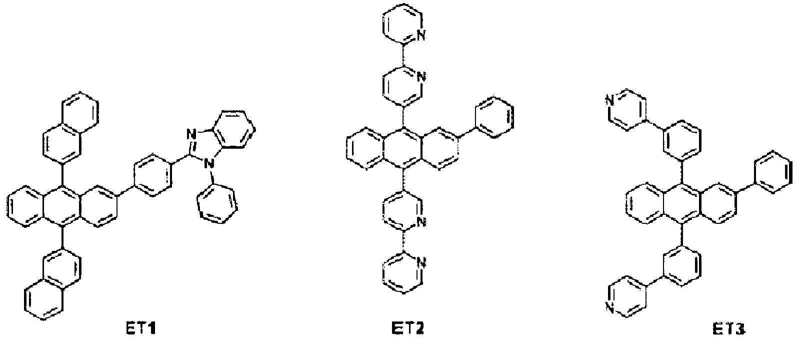

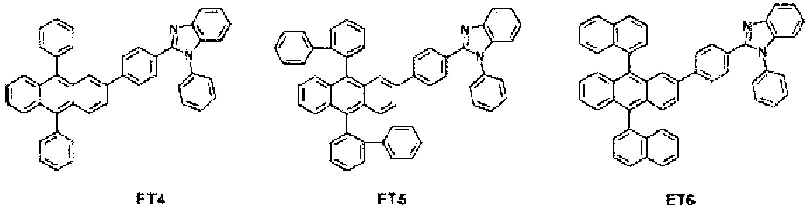

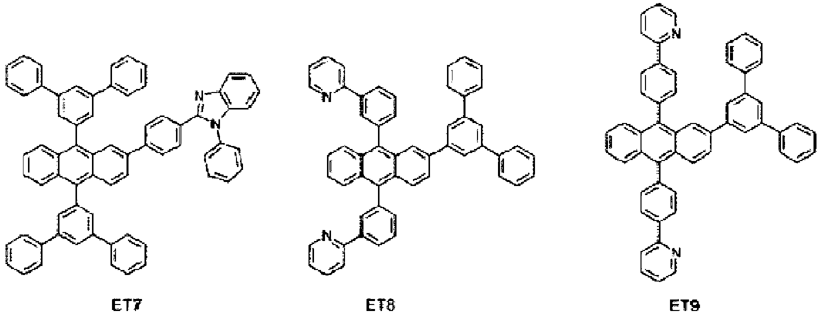

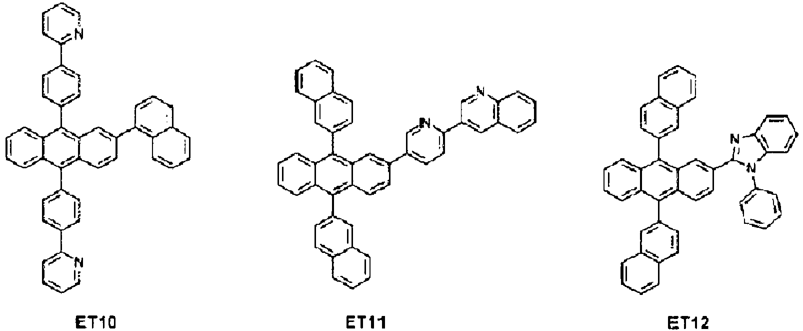

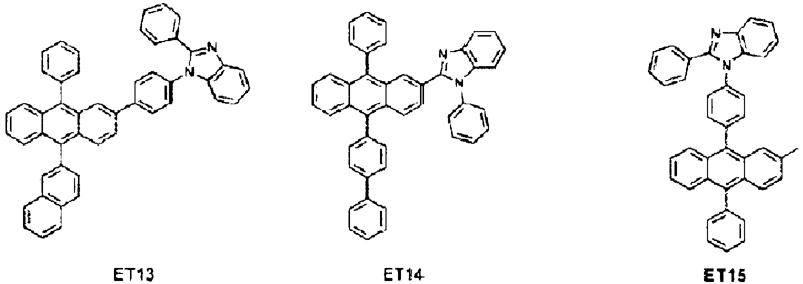

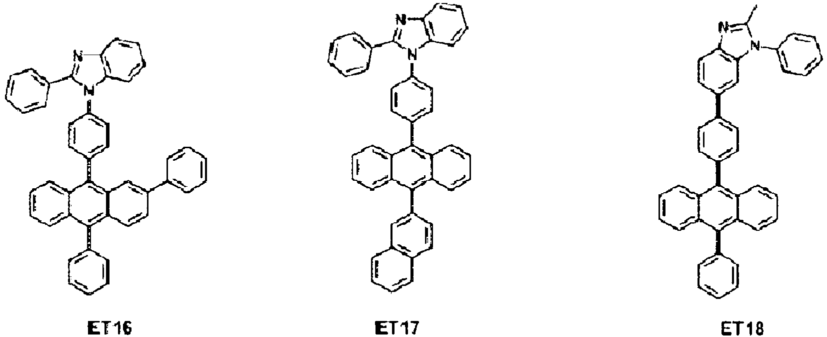

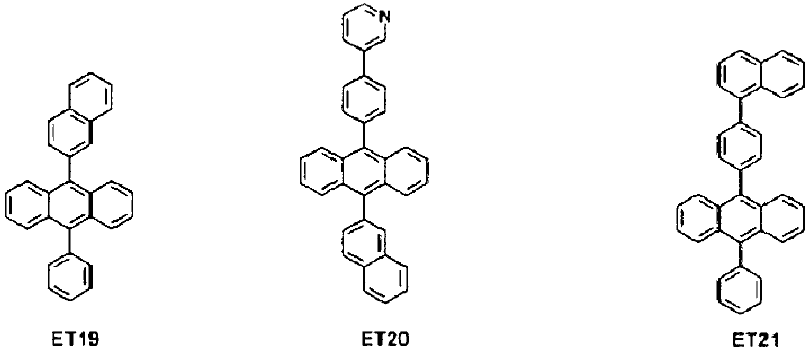

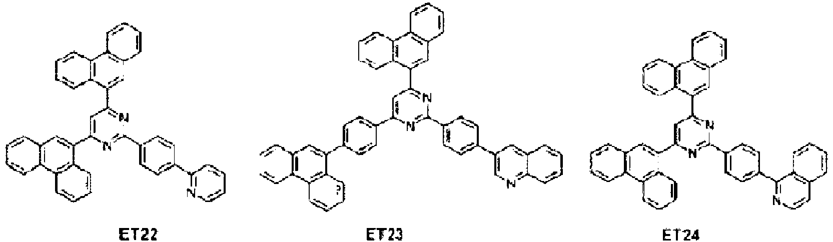

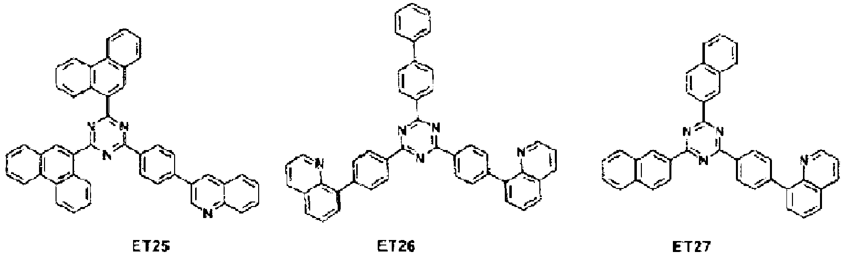

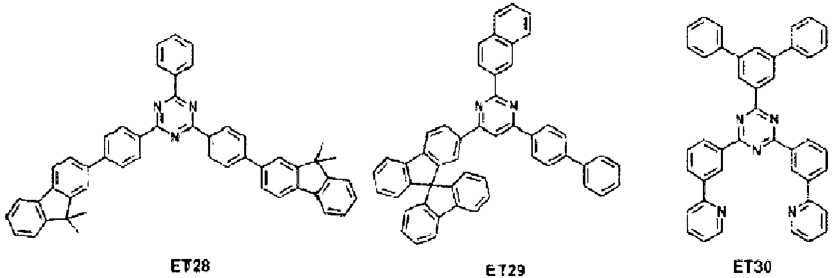

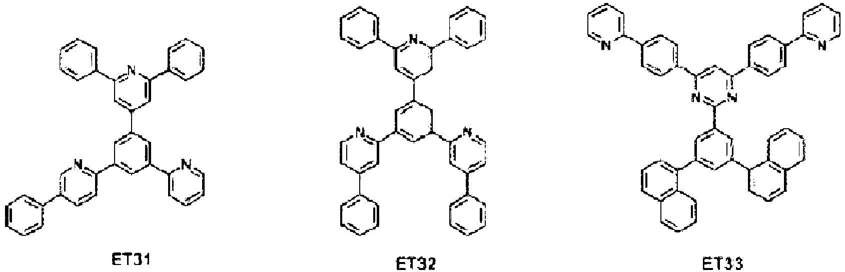

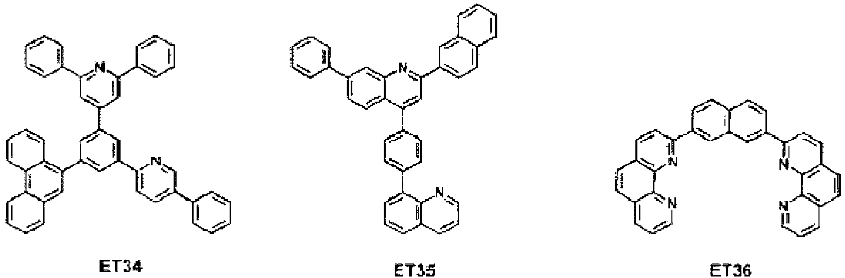

In addition, the electron transport region ETR may include a halogenated metal such as LiF, NaCl, CsF, RbCl, RbI, CuI, or KI, a lanthanum group metal such as Yb, or a co-deposition material of the halogenated metal and the lanthanum group metal. In an embodiment, the electron transport region ETR may include KI:Yb, RbI:Yb, LiF:Yb, or the like as the co-deposition material, for example. A metal oxide such as Li₂O or BaO, 8-hydroxyl-Lithium quinolate (Liq), or the like may be used for the electron transport region ETR, but the disclosure is not limited thereto. The electron transport region ETR may also include a material in which an electron transport material and an insulating organo metal salt are mixed. The organo metal salt may be a material having an energy band gap of about 4 electron-volts (eV) or more. Specifically, the organo metal salt may include metal acetate, metal benzoate, metal acetoacetate, metal acetylacetonate, or metal stearate, for example.

In addition to the foregoing material, the electron transport region ETR may further include at least one of BCP, diphenyl(4-(triphenylsilyl)phenyl)phosphine oxide ("TSPO1"), or Bphen, but the disclosure is not limited thereto.

In the electron transport region ETR, the foregoing compounds of the electron transport region may be included in at least one of the electron injection layer EIL, the electron transport layer ETL, or the hole blocking layer HBL.

In a case in which the electron transport region ETR includes the electron transport layer ETL, the electron transport layer ETL may have a thickness of about 100 Å to about 1,000 Å, e.g., about 150 Å to about 500 Å. When the thickness of the electron transport layer ETL satisfies the foregoing range, satisfactory electron transport properties may be obtained without a substantial increase in driving voltage. In a case in which the electron transport region ETR includes the electron injection layer EIL, the electron injection layer EIL may have a thickness of about 1 Å to about 100 Å, or about 3 Å to about 90 Å. When the thickness of the electron injection layer EIL satisfies the foregoing range, satisfactory electron injection properties may be obtained without a substantial increase in driving voltage.

The second electrode EL2 is provided on the electron transport region ETR. The second electrode EL2 may be a common electrode. The second electrode EL2 may be a cathode or an anode, but the disclosure is not limited thereto. In an embodiment, in a case in which the first electrode EL1 is an anode, the second electrode EL2 may be a cathode, and in a case in which the first electrode EL1 is a cathode, the second electrode EL2 may be an anode, for example.

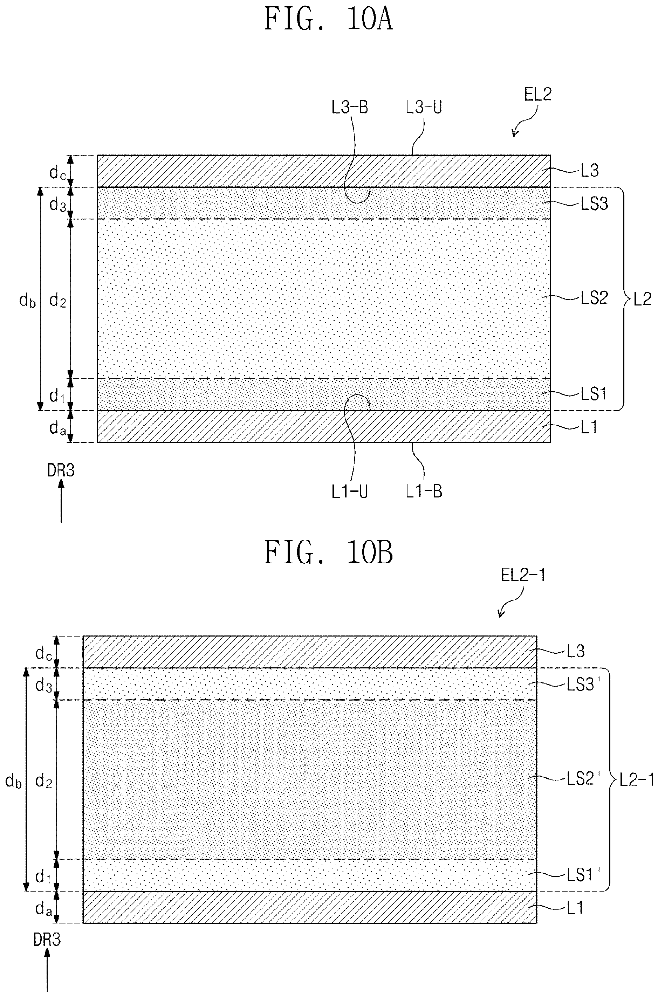

The second electrode EL2 includes silver (Ag). A portion of the second electrode EL2 may include silver (Ag). In an embodiment, a second layer L2 (refer to FIG. 10A) of the second electrode EL2 may be an electrode layer including pure silver, for example. Silver (Ag) is a metal having relatively high electrical conductivity and a relatively low light absorption, and may improve electrical characteristics and optical characteristics.

The second electrode EL2 may further include ytterbium (Yb). In ytterbium (Yb), due to a relatively low work function of Yb, an electron may be easily injected into the electron transport layer ETL to decrease a driving voltage, and due to relatively low absorption of Yb in a visible light region, the light transmittance may be improved.

The second electrode EL2 may have a thickness of about 100 Å to about 360 Å. When the thickness of the second electrode EL2 is less than about 100 Å, during film formation of the second electrode EL2, sufficient film quality may not be secured to reduce a function of the second electrode EL2. When the thickness of the second electrode EL2 is more than about 360 Å, a reflectance of the second electrode EL2 may become excessively relatively high to reduce the transmittance of the light-emitting element ED.

Although not illustrated, the second electrode EL2 may be connected to an auxiliary electrode. When the second electrode EL2 is connected to the auxiliary electrode, resistance of the second electrode EL2 may be reduced.

The capping layer CPL is disposed on the second electrode EL2 of the light-emitting element ED. The capping layer CPL may have a multilayer structure or a single-layer structure.

The capping layer CPL may have a refractive index of about 2.2 to about 2.5. Specifically, the refractive index of the capping layer CPL with respect to light in a wavelength region of about 460 nm to about 800 nm may be about 2.2 to about 2.5. The refractive index of the capping layer CPL with respect to the light in the wavelength region of about 460 nm to about 800 nm may be about 2.45.

In an embodiment, the capping layer CPL may be an organic layer or an inorganic layer. In an embodiment, in a case in which the capping layer CPL includes an inorganic material, the inorganic material may include an alkaline metal compound such as LiF, an alkaline earth metal compound such as MgF₂, SiON, SiNx, SiO_{y}, zinc oxide, titanium oxide, zirconium oxide, niobium oxide, tantalum oxide, tin oxide, nickel oxide, indium nitride, gallium nitride, or the like, for example.

In an embodiment, in a case in which the capping layer CPL includes an organic material, the organic material may include at least one of α-NPD, NPB, TPD, m-MTDATA, Alq₃, CuPc, N4,N4,N4',N4'-tetra (biphenyl-4-yl) biphenyl-4,4'-diamine (TPD15), 4,4',4"-Tris (carbazol-9-yl) triphenylamine (TCTA), Poly(3,4-ethylenedioxythiophene ("PEDOT"), 4,4'-bis[N-(3-methylphenyl)-N-phenylamino]biphenyl ("TPD"), m-MTDATA, 1,3,5-tris[N,N-bis(2-methylphenyl)-amino]benzene ("o-MTDAB"), 1,3,5-tris[N,N-bis(3-methylphenyl)-amino]benzene ("m-MTDAB"), 1,3,5-tris [N,N-bis (4-methylphenyl)amino]benzene ("p-MTDAB"), 4,4'-bis[N,N-bis(3-methylphenyl)-amino]diphenylmethane ("BPPM"), CBP, 4,4',4"-tris(N-carbazole) triphenylamine ("TCTA"), 2,2',2"-(1,3,5-benzenetolyl)tris-[1-phenyl-1H-benzoimidazol] ("TPBi"), or TAZ, for example.

The organic material included in the capping layer CPL may have a refractive index of about 2.2 to about 2.5 in a wavelength region of about 460 nm to about 800 nm.

The capping layer CPL of the light-emitting element ED in an embodiment may include at least one of compounds listed in Compound Group 1 below.

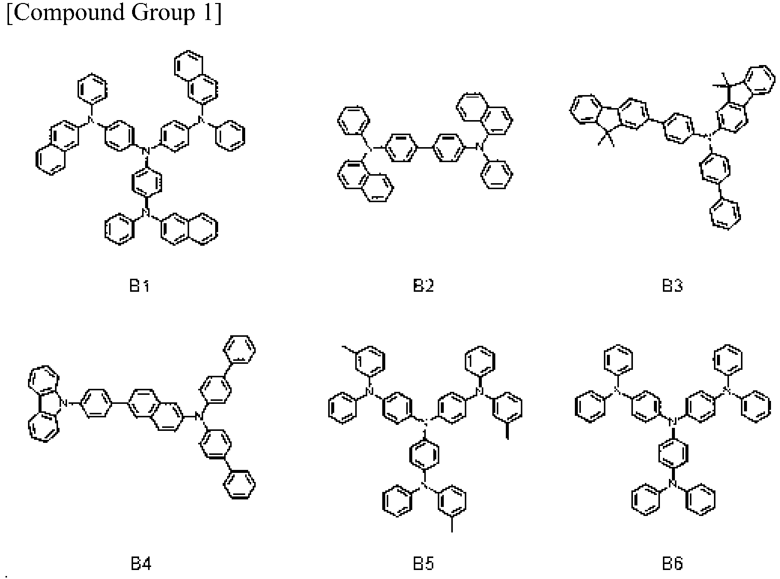

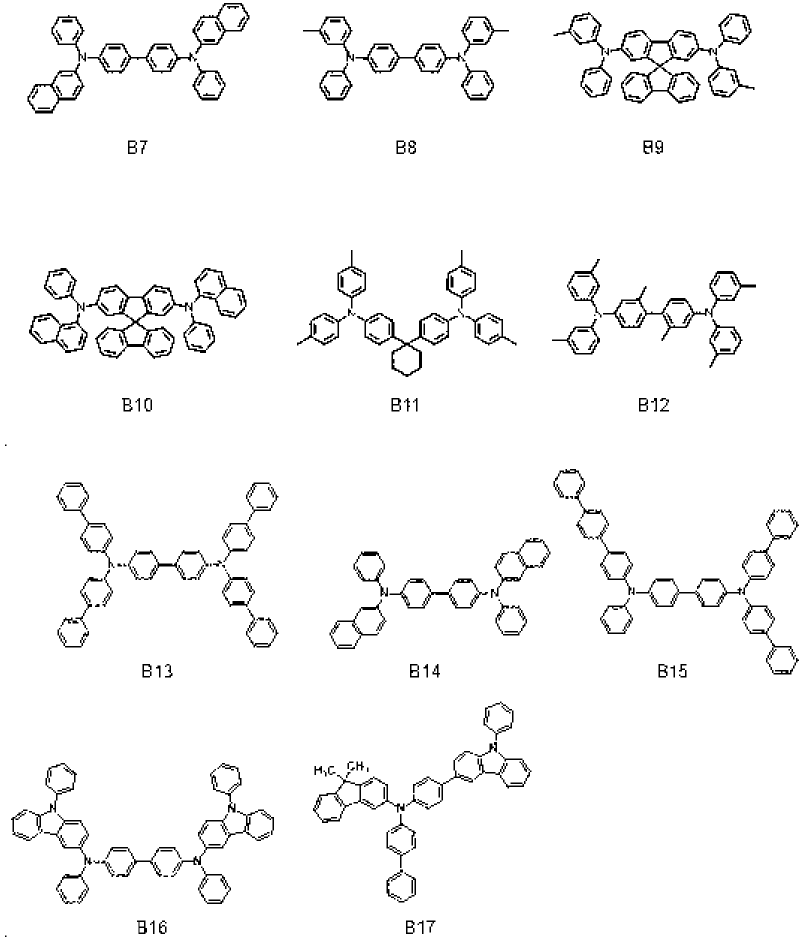

The capping layer CPL may have a thickness of about 400 Å to about 800 Å. The thickness of the capping layer CPL may be about 600 Å, for example. When the thickness of the capping layer CPL is less than about 400 Å, the light absorption of the light-emitting element ED may be excessively increased to reduce the luminous efficiency. When the thickness of the capping layer CPL is more than about 800 Å, the reflectance due to the capping layer CPL may be excessively increased to reduce the luminous efficiency, and the luminous efficiency may be significantly decreased in a relatively high viewing angle range.

The capping layer CPL may have a light transmittance of about 75% or more in a wavelength region of about 550 nm. The capping layer CPL may have a light transmittance of more than about 65% and about 90% or less in the visible light region, i.e., a wavelength region of about 450 nm to about 750 nm. The capping layer CPL may have the thickness and the refractive index as described above, and thus have the light transmittance of more than about 65% and about 90% or less in the visible light region.

The capping layer CPL may have a light reflectance of about 1% or more and less than about 30% in the wavelength region of about 450 nm to about 750 nm, and may have a light absorption of about 15% or less in the wavelength region of about 450 nm to about 750 nm. The capping layer CPL may have the thickness and the refractive index as described above, and thus have the light reflectance of about 1% or more and less than about 30% and the light absorption of about 15% or less in the visible light region.

FIGS. 10A to 10C are each a cross-sectional view of an embodiment of a second electrode.

Referring to FIGS. 7 to 10A together, a second electrode EL2 includes a first layer L1, a second layer L2, and a third layer L3 which are stacked in sequence.

The first layer L1 is disposed on a functional layer FL. The first layer L1 may be disposed on an electron transport region ETR of a light-emitting element ED. The first layer L1 may be directly disposed on the electron transport region ETR of the light-emitting element ED. A bottom surface L1-B of the first layer L1 may contact the functional layer FL disposed below the first layer L1.

The second layer L2 is disposed on the first layer L1. The second layer L2 may be directly disposed on the first layer L1. The second layer L2 includes a different material from that of the first layer L1.

The third layer L3 is disposed on the second layer L2. The third layer L3 may be directly disposed on the second layer L2. The third layer L3 includes a different material from that of the second layer L2. The third layer L3 may include the same material as that of the first layer L1. A top surface L3-U of the third layer L3 may contact a capping layer CPL disposed on the second electrode EL2.

The second layer L2 includes a plurality of sub-layers. The second layer L2 may include at least three sub-layers. The second layer L2 may include a first sub-layer LS1, a second sub-layer LS2, and a third sub-layer LS3 which are stacked in sequence.

The plurality of sub-layers included in the second layer L2 include the same metal material. In an embodiment, each of the plurality of sub-layers included in the second layer L2 includes silver (Ag). Each of the plurality of sub-layers included in the second layer L2 may include or consist of silver (Ag). Each of the plurality of sub-layers included in the second layer L2 may be an electrode layer including pure silver. Silver (Ag) is a metal having relatively high electrical conductivity and a relatively low light absorption, and may improve electrical characteristics and optical characteristics.

The first sub-layer LS1 is disposed on the first layer L1. The first sub-layer LS1 may be directly disposed on the first layer L1. The first sub-layer LS1 may contact a top surface L1-U of the first layer L1. The second sub-layer LS2 is disposed on the first sub-layer LS1. The second sub-layer LS2 may be directly disposed on the first sub-layer LS1. The third sub-layer LS3 is disposed on the second sub-layer LS2. The third sub-layer LS3 may be directly disposed on the second sub-layer LS2. The third layer L3 may be directly disposed on the third sub-layer LS3. The third sub-layer LS3 may contact a bottom surface L3-B of the third layer L3.

The first sub-layer LS1, the second sub-layer LS2, and the third sub-layer LS3 may have a shape of a single body. A separate interface may not be in each space between the first sub-layer LS1, the second sub-layer LS2, and the third sub-layer LS3. The first sub-layer LS1, the second sub-layer LS2, and the third sub-layer LS3 may not be layers separated from each other with an interface, but be divided portions having different properties, such as film density, in one second layer L2.

In an embodiment, a film density of the first sub-layer LS1 and a film density of the second sub-layer LS2 are different. The film density of the second sub-layer LS2 and a film density of the third sub-layer LS3 are different. Each of the first sub-layer LS1, the second sub-layer LS2, and the third sub-layer LS3 may be an electrode layer including pure silver, but be a divided portion having a different film density from neighboring (adjacent) layers.

In an embodiment illustrated in FIG. 10A, the film density of the second sub-layer LS2 may be lower than the film density of each of the first sub-layer LS1 and the third sub-layer LS3. The first sub-layer LS1 may have a first film density, the second sub-layer LS2 may have a second film density, and the third sub-layer LS3 may have a third film density. The second film density may be lower than each of the first film density and the third film density. In an operation of forming the second sub-layer LS2, silver may be provided at a lower deposition rate than in an operation of forming each of the first sub-layer LS1 and the third sub-layer LS3, so that the second film density is lower than each of the first film density and the third film density.

A difference between each of the first film density and the third film density and the second film density may be about 1 gram per cubic centimeter (g/cm³) or more. The second film density may be about 9 g/cm³ to about 10 g/cm³, for example. Each of the first film density and the third film density may be about 10.3 g/cm³ to about 11.5 g/cm³, for example.

The first film density and the third film density may be substantially the same. The first sub-layer LS1 and the third sub-layer LS3 may be formed by providing silver at substantially the same deposition rate during the layer formation, and thus have substantially the same film density. In the disclosure, when the film densities, the deposition rates, or the like are "substantially the same", it includes not only a case in which numerical values are the same in terms of physical measurements, but also a case in which despite the same design, there is a difference as much as a margin of error occurring during a process.

Each of the first sub-layer LS1 and the third sub-layer LS3 may have a smaller thickness than the second sub-layer LS2. Each of a thickness d₁ of the first sub-layer LS1 and a thickness d₃ of the third sub-layer LS3 may be about 20 Å to about 30 Å, for example. When each of the thickness d₁ of the first sub-layer LS1 and the thickness d₃ of the third sub-layer LS3 is less than about 20 Å, an amount of silver (Ag) diffused to the first layer L1 and the third layer L3, which are next (adjacent) to the second layer L2, may be increased to decrease reliability of the second electrode EL2. When each of the thickness d₁ of the first sub-layer LS1 and the thickness d₃ of the third sub-layer LS3 is more than about 30 Å, a degree at which a silver (Ag) thin film is oxidized may be increased to decrease film characteristics.

The second sub-layer LS2 having the lower film density may have a larger thickness than other sub-layers. A thickness d₂ of the second sub-layer LS2 may be about 50 Å to about 70 Å, for example. When the thickness d₂ of the second sub-layer LS2 is less than about 50 Å, during the film formation of the second layer L2 formed using silver, the sufficient film quality may not be secured to reduce the function of the second electrode EL2. When the thickness d₂ of the second sub-layer LS2 is more than about 70 Å, a film formation time may be increased and the reflectance of the second electrode EL2 may be excessively increased, thereby decreasing the light transmittance of the light-emitting element ED.

Each of the first layer L1 and the third layer L3 includes a different material from that of the second layer L2. Each of the first layer L1 and the third layer L3 does not include silver. Each of the first layer L1 and the third layer L3 may include a material having a relatively low work function. Each of the first layer L1 and the third layer L3 may include ytterbium, for example. Each of the first layer L1 and the third layer L3 may include or consist of ytterbium. In ytterbium (Yb), due to a relatively low work function of Yb, an electron may be easily injected into the electron transport region ETR to decrease a driving voltage, and due to relatively low absorption of Yb in the visible light region, the light transmittance may be improved. Each of the first layer L1 and the third layer L3 may include a material other than ytterbium. Each of the first layer L1 and the third layer L3 may include a halogenated metal, a lanthanum group metal, or a co-deposition material of the halogenated metal and the lanthanum group metal, for example. Each of the first layer L1 and the third layer L3 may include the halogenated metal such as LiF, NaCl, CsF, RbCl, RbI, CuI, or KI, the lanthanum group metal such as Yb, or the co-deposition material of the halogenated metal and the lanthanum group metal. In an embodiment, each of the first layer L1 and the third layer L3 may include KI:Yb, RbI:Yb, LiF:Yb, or the like, as the co-deposition material, for example.

Each of the first layer L1 and the third layer L3 may have a smaller thickness than the second layer L2. Each of a thickness dₐ of the first layer L1 and a thickness d_{c} of the third layer L3 may be about 5 Å to about 30 Å, for example. When each of the thickness dₐ of the first layer L1 and the thickness d_{c} of the third layer L3 is less than about 5 Å, a characteristic in which an electron is injected toward the electron transport region ETR may be decreased. When each of the thickness dₐ of the first layer L1 and the thickness d_{c} of the third layer L3 is more than about 30 Å, a total thickness of the second electrode EL2 may be increased and the reflectance may be increased.

In the second electrode EL2, the second layer L2 may have a larger thickness than other layers. A thickness d_{b} of the second layer L2 may be about 90 Å to about 300 Å (e.g. about 90 Å to about 130 Å), for example. When the thickness d_{b} of the second layer L2 is less than about 90 Å, during the film formation of the second electrode EL2, the sufficient film quality may not be secured to reduce the function of the second electrode EL2. When the thickness d_{b} of the second layer L2 is more than about 300 Å, the reflectance of the second electrode EL2 may become excessively high, thereby decreasing the transmittance of the light-emitting element ED.

The second electrode EL2 of the light-emitting element ED in an embodiment includes the layers including different materials, the second layer L2 including silver (Ag) and the first layer L1 and the third layer L3 each including a different material from that of the second layer L2, and also at least a portion of the plurality of sub-layers LS1, LS2 and LS3 included in the second layer L2 is provided to have the different film density. Specifically, the second layer L2 may include the first sub-layer LS1 and the third sub-layer LS3 each having the relatively high film density, and the second sub-layer LS2 having the relatively low film density and disposed between the first sub-layer LS1 and the third sub-layer LS3. Accordingly, during the formation of the second layer L2, aggregation of silver may be prevented and silver may be prevented from being diffused to the next (adjacent) first layer L1 and third layer L3, thereby improving the luminous efficiency and the element lifespan of the light-emitting element ED including the second electrode EL2. Moreover, in an embodiment illustrated in FIG. 10A, the first sub-layer LS1 and the third sub-layer LS3, which are respectively next (adjacent) to the first layer L1 and the third layer L3, of the second layer L2 may each have the relatively high film density, and accordingly, silver may be prevented from being diffused to the neighboring (adjacent) layers to improve the reliability of the light-emitting element ED.

Referring to FIG. 10B, compared to the second electrode EL2 illustrated in FIG. 10A, a second electrode EL2-1 may include a second layer L2-1 disposed between a first layer L1 and a third layer L3, and the second layer L2-1 may include a first sub-layer LS1', a second sub-layer LS2', and a third sub-layer LS3' which are stacked in sequence.

The plurality of sub-layers included in the second layer L2-1 include the same metal material. In an embodiment, each of the plurality of sub-layers included in the second layer L2-1 includes silver (Ag). Each of the plurality of sub-layers included in the second layer L2-1 may include or consist of silver (Ag). Each of the plurality of sub-layers included in the second layer L2-1 may be an electrode layer including pure silver. Silver (Ag) is a metal having relatively high electrical conductivity and relatively low light absorption, and may improve electrical characteristics and optical characteristics.

The first sub-layer LS1' is disposed on the first layer L1. The first sub-layer LS1' may be directly disposed on the first layer L1. The first sub-layer LS1' may contact a top surface L1-U of the first layer L1. The second sub-layer LS2' is disposed on the first sub-layer LS1'. The second sub-layer LS2' may be directly disposed on the first sub-layer LS1'. The third sub-layer LS3' is disposed on the second sub-layer LS2'. The third sub-layer LS3' may be directly disposed on the second sub-layer LS2'. The third layer L3 may be directly disposed on the third sub-layer LS3'.

The first sub-layer LS1', the second sub-layer LS2', and the third sub-layer LS3' may have a shape of a single body. A separate interface may not be in each space between the first sub-layer LS1', the second sub-layer LS2', and the third sub-layer LS3'. The first sub-layer LS1', the second sub-layer LS2', and the third sub-layer LS3' may not be layers separated from each other with an interface, but be divided portions having different properties, such as film density, in one second layer L2-1.

In an embodiment, a film density of the first sub-layer LS1' and a film density of the second sub-layer LS2' are different. The film density of the second sub-layer LS2' and a film density of the third sub-layer LS3' are different. Each of the first sub-layer LS1', the second sub-layer LS2', and the third sub-layer LS3' may be an electrode layer including pure silver, but be a divided portion having a different film density from neighboring (adjacent) layers.

In an embodiment illustrated in FIG. 10B, a film density of the second sub-layer LS2' may be higher than a film density of each of the first sub-layer LS1' and the third sub-layer LS3'. The first sub-layer LS1' may have a first film density, the second sub-layer LS2' may have a second film density, and the third sub-layer LS3' may have a third film density. The second film density may be higher than each of the first film density and the third film density. In an operation of forming the second sub-layer LS2', silver may be provided at a higher deposition rate than in an operation of forming each of the first sub-layer LS1' and the third sub-layer LS3' so that the second film density is higher than each of the first film density and the third film density.

A difference between each of the first film density and the third film density and the second film density may be about 1g/cm³ or more. The second film density may be about 10.3 g/cm³ to about 11.5 g/cm³, for example. Each of the first film density and the third film density may be about 9 g/cm³ to about 10 g/cm³, for example.

The first film density and the third film density may be substantially the same. The first sub-layer LS1' and the third sub-layer LS3' may be formed by providing silver at substantially the same deposition rate during the layer formation, and thus have substantially the same film density.

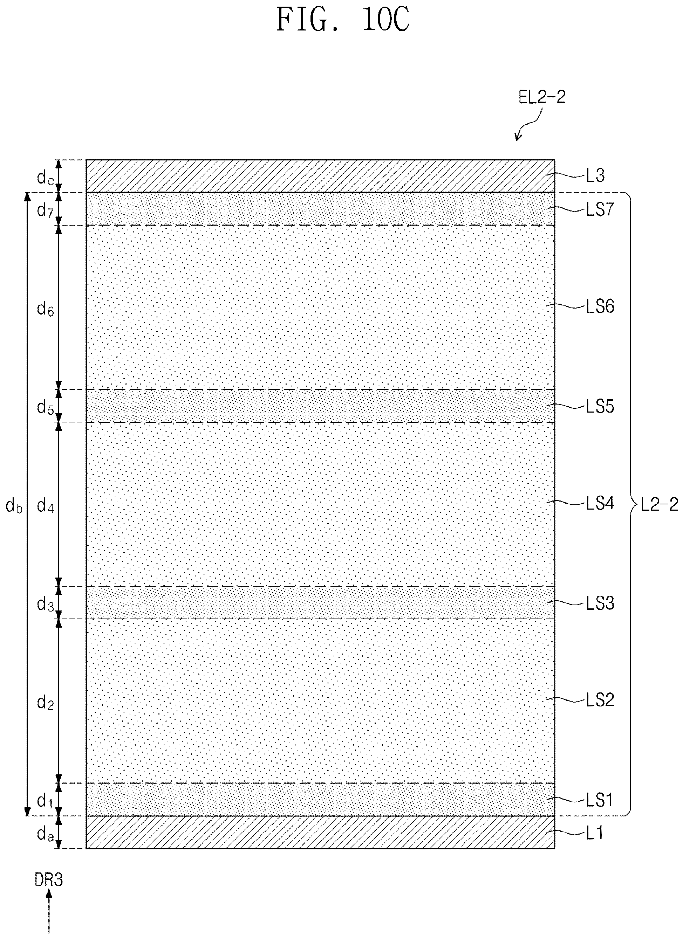

Referring to FIG. 10C, compared to the second electrode EL2 illustrated in FIG. 10A, a second electrode EL2-2 may include a second layer L2-2 disposed between a first layer L1 and a third layer L3, and the second layer L2-2 may include a plurality of sub-layers. The second layer L2-2 may include seven sub-layers having different film densities as illustrated in FIG. 10C, for example. However, the second layer L2-2 is not limited to an embodiment illustrated in FIG. 10C, and the second layer L2-2 may include five sub-layers having different film densities or nine or more sub-layers having different film densities.

The second layer L2-2 may include a first sub-layer LS1, a second sub-layer LS2, a third sub-layer LS3, a fourth sub-layer LS4, a fifth sub-layer LS5, a sixth sub-layer LS6, and a seventh sub-layer LS7 which are stacked in sequence. The plurality of sub-layers included in the second layer L2-2 include the same metal material. In an embodiment, each of the plurality of sub-layers included in the second layer L2-2 includes silver (Ag). Each of the plurality of sub-layers included in the second layer L2-2 may include or consist of silver (Ag). Each of the plurality of sub-layers included in the second layer L2-2 may be an electrode layer including pure silver.

The first sub-layer LS1 is disposed on the first layer L1. The first sub-layer LS1 may be directly disposed on the first layer L1. The second sub-layer LS2 is disposed on the first sub-layer LS1. The second sub-layer LS2 may be directly disposed on the first sub-layer LS1. The third sub-layer LS3 is disposed on the second sub-layer LS2. The third sub-layer LS3 may be directly disposed on the second sub-layer LS2. The fourth sub-layer LS4 is disposed on the third sub-layer LS3. The fourth sub-layer LS4 may be directly disposed on the third sub-layer LS3. The fifth sub-layer LS5 is disposed on the fourth sub-layer LS4. The fifth sub-layer LS5 may be directly disposed on the fourth sub-layer LS4. The sixth sub-layer LS6 is disposed on the fifth sub-layer LS5. The sixth sub-layer LS6 may be directly disposed on the fifth sub-layer LS5. The seventh sub-layer LS7 is disposed on the sixth sub-layer LS6. The seventh sub-layer LS7 may be directly disposed on the sixth sub-layer LS6.

The first sub-layer LS1 to the seventh sub-layer LS7 may have a shape of a single body. A separate interface may not be in each space between the first sub-layer LS1 to the seventh sub-layer LS7. The first sub-layer LS1 to the seventh sub-layer LS7 may not be layers separated from each other with an interface, but be divided portions having different properties, such as film density, in one second layer L2-2.

In an embodiment, each of the sub-layers included in the second layer L2-2 may have a different film density from neighboring (adjacent) layers. Each of the first sub-layer LS1 to the seventh sub-layer LS7 may be an electrode layer including pure silver, but be a divided portion having a different film density from neighboring (adjacent) layers.

In an embodiment illustrated in FIG. 10C, a film density of each of the second sub-layer LS2, the fourth sub-layer LS4, and the sixth sub-layer LS6 may be lower than a film density of each of the first sub-layer LS1, the third sub-layer LS3, the fifth sub-layer LS5, and the seventh sub-layer LS7. The film density of each of the second sub-layer LS2, the fourth sub-layer LS4, and the sixth sub-layer LS6 may be lower than the film density of each of the first sub-layer LS1, the third sub-layer LS3, the fifth sub-layer LS5, and the seventh sub-layer LS7. In an operation of forming each of the second sub-layer LS2, the fourth sub-layer LS4, and the sixth sub-layer LS6, silver may be provided at a lower deposition rate than in an operation of forming each of the first sub-layer LS1, the third sub-layer LS3, the fifth sub-layer LS5, and the seventh sub-layer LS7 so that the film density of each of the second sub-layer LS2, the fourth sub-layer LS4, and the sixth sub-layer LS6 is lower than the film density of each of the first sub-layer LS1, the third sub-layer LS3, the fifth sub-layer LS5, and the seventh sub-layer LS7.

A difference between the film density of each of the second sub-layer LS2, the fourth sub-layer LS4, and the sixth sub-layer LS6 and the film density of each of the first sub-layer LS1, the third sub-layer LS3, the fifth sub-layer LS5, and the seventh sub-layer LS7 may be about 1g/cm³ or more. The film density of each of the second sub-layer LS2, the fourth sub-layer LS4, and the sixth sub-layer LS6 may be about 9 g/cm³ to about 10 g/cm³, for example. The film density of each of the first sub-layer LS1, the third sub-layer LS3, the fifth sub-layer LS5, and the seventh sub-layer LS7 may be about 10.3 g/cm³ to about 11.5 g/cm³, for example.

The respective film densities of the first sub-layer LS1, the third sub-layer LS3, the fifth sub-layer LS5, and the seventh sub-layer LS7 may be substantially the same. The first sub-layer LS1, the third sub-layer LS3, the fifth sub-layer LS5, and the seventh sub-layer LS7 may be formed by providing silver at substantially the same deposition rate during the layer formation, and thus have substantially the same film density. The respective film densities of the second sub-layer LS2, the fourth sub-layer LS4, and the sixth sub-layer LS6 may be substantially the same. The second sub-layer LS2, the fourth sub-layer LS4, and the sixth sub-layer LS6 may be formed by providing silver at substantially the same deposition rate during the layer formation, and thus have substantially the same film density.

Each of the first sub-layer LS1, the third sub-layer LS3, the fifth sub-layer LS5, and the seventh sub-layer LS7 may have a smaller thickness than each of the second sub-layer LS2, the fourth sub-layer LS4, and the sixth sub-layer LS6. Each of a thickness d₁ of the first sub-layer LS1, a thickness d₃ of the third sub-layer LS3, a thickness d₅ of the fifth sub-layer LS5, and a thickness d₇ of the seventh sub-layer LS7 may be about 20 Å to about 30 Å, for example.

Each of the second sub-layer LS2, the fourth sub-layer LS4, and the sixth sub-layer LS6 having the relatively low film densities may have a relatively large thickness. Each of a thickness d₂ of the second sub-layer LS2, a thickness d₄ of the fourth sub-layer LS4, and a thickness d₆ of the sixth sub-layer LS6 may be about 50 Å to about 70 Å, for example.

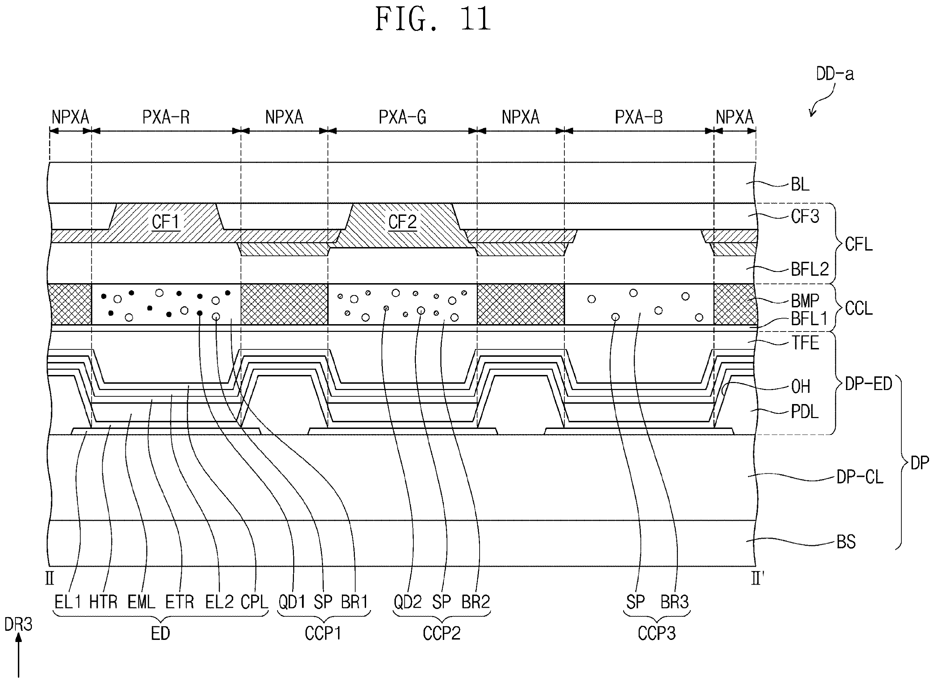

FIGS. 11 to 14 are each a cross-sectional view of an embodiment of an electronic device. Hereinafter, the electronic device in an embodiment will be described with reference to FIGS. 11 to 14 by avoiding the contents in common with the contents described with reference to FIGS. 1 to 9, and mainly in terms of differences.

Referring to FIG. 11, an electronic device DD-a in an embodiment may include a display panel DP including a display element layer DP-ED, and a light control layer CCL and a color filter layer CFL which are disposed on the display panel DP. In an embodiment illustrated in FIG. 11, the display panel DP may include a base layer BS, and a circuit layer DP-CL and the display element layer DP-ED which are disposed on the base layer BS, and the display element layer DP-ED may include a light-emitting element ED.

The light-emitting element ED may include a first electrode EL1, a hole transport region HTR disposed on the first electrode EL1, an emission layer EML disposed on the hole transport region HTR, an electron transport region ETR disposed on the emission layer EML, a second electrode EL2 disposed on the electron transport region ETR, and a capping layer CPL disposed on the second electrode EL2. The structure as/to that of the light-emitting element ED described with reference to FIGS. 7 to 9 may apply a structure of the light-emitting element ED illustrated in FIG. 11. The contents about the respective materials, thicknesses, refractive indexes, or the like of the second electrode EL2 and the capping layer CPL of the light-emitting element ED described with reference to FIGS. 7 to 9 may apply to the second electrode EL2 and the capping layer CPL of the light-emitting element ED included in the electronic device DD-a.

Referring to FIG. 11, the emission layer EML may be disposed in an opening portion OH defined in a pixel defining film PDL. In an embodiment, the emission layer EML, which is divided by the pixel defining film PDL and corresponds to each of emission areas PXA-R, PXA-G and PXA-B, may emit light in the same wavelength region, for example. In the electronic device DD-a in an embodiment, the emission layer EML may emit blue light. However, unlike the illustrated embodiment, the emission layer EML may be provided as a common layer over the entirety of the emission areas PXA-R, PXA-G and PXA-B.

The light control layer CCL may be disposed on the display panel DP. The light control layer CCL may include a photoconversion material. The photoconversion material may be a quantum dot, a phosphor, or the like. The photoconversion material may convert a wavelength of received light and emit the light. That is, the light control layer CCL may be a layer including the quantum dot or a layer including the phosphor.

The light control layer CCL may include a plurality of light control parts CCP1, CCP2 and CCP3. The light control parts CCP1, CCP2 and CCP3 may be spaced apart from each other.

Referring to FIG. 11, a division pattern BMP may be disposed between the light control parts CCP1, CCP2 and CCP3 spaced apart from each other, but the disclosure is not limited thereto. FIG. 11 illustrates the division patterns BMP nonoverlapping the light control parts CCP1, CCP2 and CCP3, but at least a portion of an edge of each of the light control parts CCP1, CCP2 and CCP3 may overlap the division pattern BMP.

The light control layer CCL may include a first light control part CCP1 including a first quantum dot QD1 which converts light of a first color, provided from the light-emitting element ED, to light of a second color, a second light control part CCP2 including a second quantum dot QD2 which converts the light of the first color to light of a third color, and a third light control part CCP3 which transmits the light of the first color. In an embodiment, the first light control part CCP1 may provide red light that is the light of the second color, and the second light control part CCP2 may provide green light that is the light of the third color. The third light control part CCP3 may transmit and provide blue light that is the light of the first color provided from the light-emitting element ED. In an embodiment, the first quantum dot QD1 may be a red quantum dot, and the second quantum dot QD2 may be a green quantum dot, for example. The contents described above may apply to the quantum dots QD1 and QD2.

In addition, the light control layer CCL may further include a scatterer SP. The first light control part CCP1 may include the first quantum dot QD1 and the scatterer SP, the second light control part CCP2 may include the second quantum dot QD2 and the scatterer SP, and the third light control part CCP3 may not include a quantum dot but include the scatterer SP.

The scatterer SP may be an inorganic particle. In an embodiment, the scatterer SP may include at least one of TiO₂, ZnO, Al₂O₃, SiO₂, or hollow silica, for example. The scatterer SP may include any one of TiO₂, ZnO, Al₂O₃, SiO₂, or hollow silica, or may be any combinations of two or more materials selected from TiO₂, ZnO, Al₂O₃, SiO₂, or hollow silica.

The first light control part CCP1, the second light control part CCP2, and the third light control part CCP3 may respectively include base resins BR1, BR2 and BR3 which disperse the quantum dots QD1 and QD2 and the scatterers SP. In an embodiment, the first light control part CCP1 may include the first quantum dot QD1 and the scatterer SP dispersed in a first base resin BR1, the second light control part CCP2 may include the second quantum dot QD2 and the scatterer SP dispersed in a second base resin BR2, and the third light control part CCP3 may include the scatterer SP dispersed in a third base resin BR3.

The base resins BR1, BR2 and BR3 are mediums in which the quantum dots QD1 and QD2 and the scatterers SP are dispersed, and may include various resin compositions which may be generally referred to as binders. In an embodiment, the base resins BR1, BR2 and BR3 may each be an acrylic resin, a urethane-based resin, a silicone-based resin, an epoxy-based resin, or the like, for example. The base resins BR1, BR2 and BR3 may each be a transparent resin. In an embodiment, the first base resin BR1, the second base resin BR2, and the third base resin BR3 may be the same or different.

The light control layer CCL may include a barrier layer BFL1. The barrier layer BFL1 may serve to prevent penetration of moisture and/or oxygen (hereinafter referred to as "moisture/oxygen"). The barrier layer BFL1 may prevent the light control parts CCP1, CCP2 and CCP3 from being exposed to moisture/oxygen. The barrier layer BFL1 may cover the light control parts CCP1, CCP2 and CCP3. In addition, a barrier layer BFL2 may also be provided between the light control parts CCP1, CCP2 and CCP3 and the color filter layer CFL.

The barrier layers BFL1 and BFL2 may include at least one inorganic layer. That is, the barrier layers BFL1 and BFL2 may include an inorganic material. In an embodiment, the barrier layers BFL1 and BFL2 may include silicon nitride, aluminium nitride, zirconium nitride, titanium nitride, hafnium nitride, tantalum nitride, silicon oxide, aluminium oxide, titanium oxide, tin oxide, cerium oxide, and silicon oxynitride, or a metal thin film having a light transmittance or the like, for example. The barrier layers BFL1 and BFL2 may further include an organic film. The barrier layers BFL1 and BFL2 may each include a single layer or a plurality of layers.

In the electronic device DD-a in an embodiment, the color filter layer CFL may be disposed on the light control layer CCL. In an embodiment, the color filter layer CFL may be directly disposed on the light control layer CCL, for example. In this case, the barrier layer BFL2 may be omitted.

The color filter layer CFL may include filters CF1, CF2 and CF3. First to third filters CF1, CF2 and CF3 may be arranged to correspond to a red emission area PXA-R, a green emission area PXA-G, and a blue emission area PXA-B, respectively.

The color filter layer CFL may include the first filter CF1 which transmits the light of the second color, the second filter CF2 which transmits the light of the third color, and the third filter CF3 which transmits the light of the first color. In an embodiment, the first filter CF1 may be a red filter, the second filter CF2 may be a green filter, and the third filter CF3 may be a blue filter, for example. Each of the filters CF1, CF2 and CF3 may include a polymer photosensitive resin and a pigment or a dye. The first filter CF1 may include a red pigment or dye, the second filter CF2 may include a green pigment or dye, and the third filter CF3 may include a blue pigment or dye.

However, the disclosure is not limited thereto, the third filter CF3 may not include a pigment or dye. The third filter CF3 may include a polymer photosensitive resin but not include a pigment or dye. The third filter CF3 may be transparent. The third filter CF3 may include a transparent photosensitive resin.

In addition, in an embodiment, the first filter CF1 and the second filter CF2 may be yellow filters. The first filter CF1 and the second filter CF2 may not be divided but provided as a single body.

Although not illustrated, the color filter layer CFL may further include a light-blocking part (not illustrated). The light-blocking part may be a black matrix. The light-blocking part may include an organic light-blocking material or an inorganic light-blocking material each including a black pigment or a black dye. The light-blocking part may prevent light leakage and define a boundary between neighboring (adjacent) filters of the filters CF1, CF2 and CF3.

A base substrate BL may be disposed on the color filter layer CFL. The base substrate BL may be a member that provides a base surface on which the color filter layer CFL, the light control layer CCL, or the like are disposed. The base substrate BL may be a glass substrate, a metal substrate, a plastic substrate, or the like. However, the disclosure is not limited thereto, and the base substrate BL may be an inorganic layer, an organic layer, or a composite material layer. In an alternative embodiment, unlike the illustrated embodiment, the base substrate BL may be omitted in an embodiment.

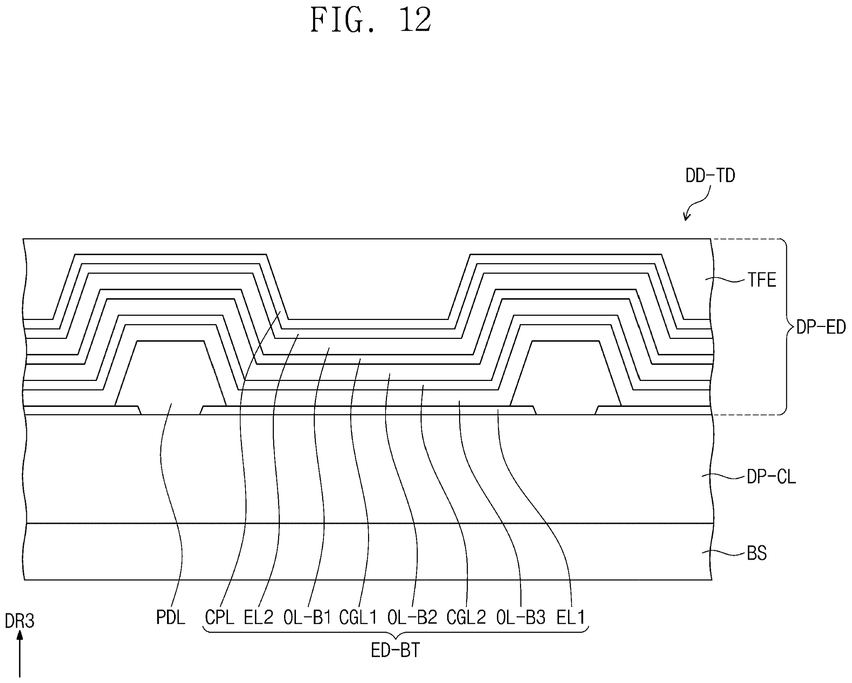

FIG. 12 is a cross-sectional view illustrating an embodiment of a portion of a display device. In an electronic device DD-TD in an embodiment, a light-emitting element ED-BT may include a plurality of emission structures OL-B1, OL-B2 and OL-B3. The light-emitting element ED-BT may include a first electrode EL1 and a second electrode EL2 facing each other, and the plurality of emission structures OL-B1, OL-B2 and OL-B3 stacked in sequence between the first electrode EL1 and the second electrode EL2 in the thickness direction. Each of the emission structures OL-B1, OL-B2 and OL-B3 may include the emission layer EML (refer to FIG. 11), and the hole transport region HTR (refer to FIG. 11) and the electron transport region ETR (refer to FIG. 11) between which the emission layer EML (refer to FIG. 11) is disposed.

That is, the light-emitting element ED-BT included in the electronic device DD-TD in an embodiment may be a light-emitting element having a tandem structure including a plurality of emission layers.

In an embodiment illustrated in FIG. 12, light emitted from the emission structures OL-B1, OL-B2 and OL-B3 may be all blue light. However, the disclosure is not limited thereto, and wavelength regions of the light emitted from the emission structures OL-B1, OL-B2 and OL-B3 may be different. In an embodiment, the light-emitting element ED-BT including the plurality of emission structures OL-B1, OL-B2 and OL-B3, which emit the light in the different wavelength regions, may emit white light, for example.

Each of charge generation layers CGL1 and CGL2 may be disposed between neighboring emission structures of the emission structures OL-B1, OL-B2 and OL-B3. The charge generation layers CGL1 and CGL2 may include a p-type charge generation layer and/or a n-type charge generation layer.

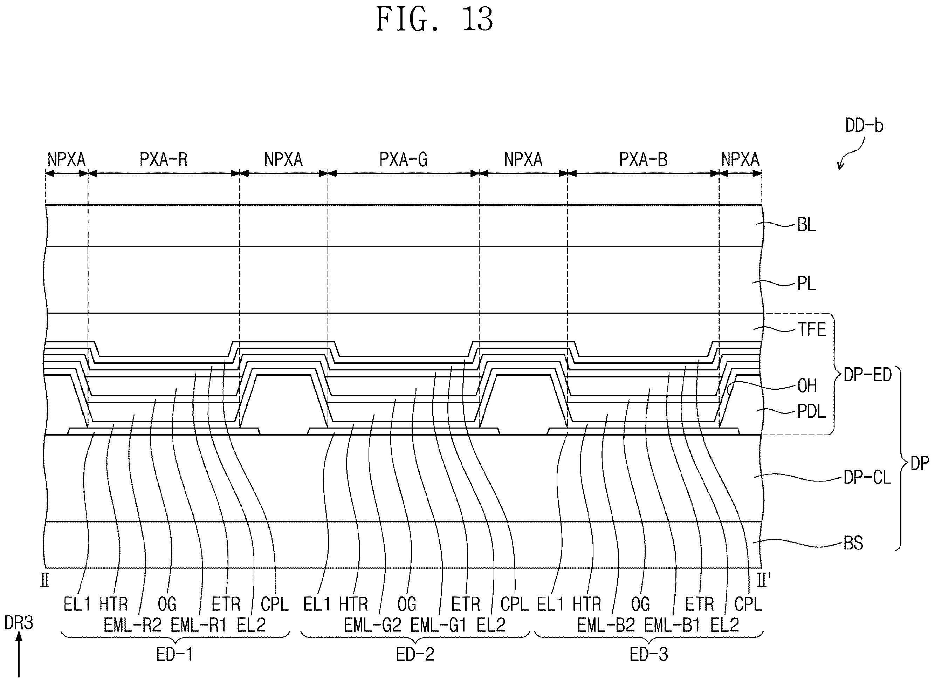

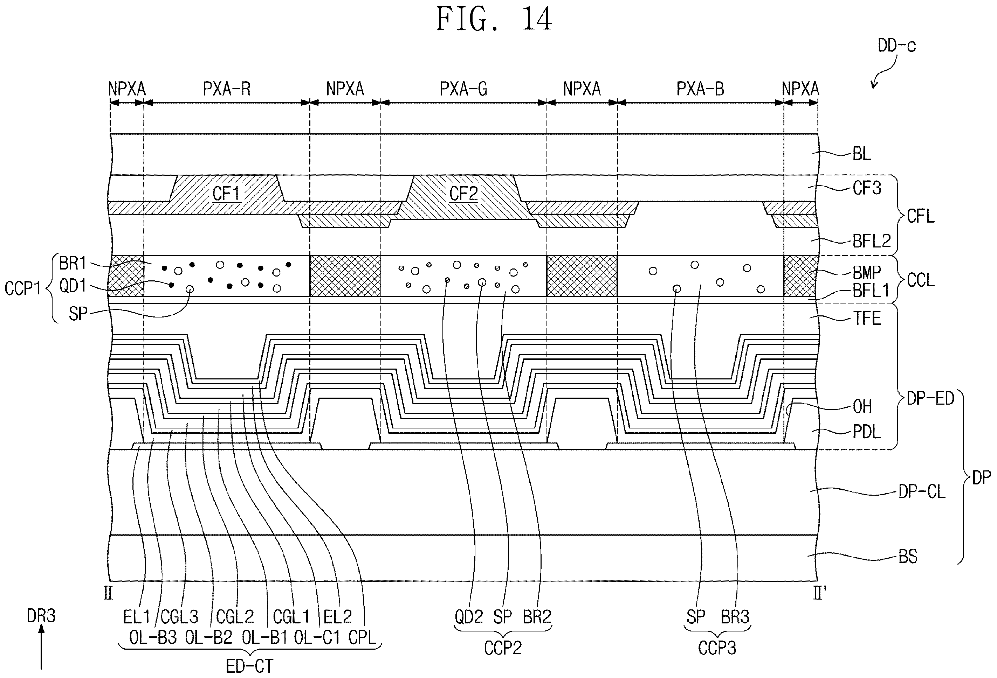

FIG. 13 is a cross-sectional view illustrating an embodiment of an electronic device according to the inventive concept. FIG. 14 is a cross-sectional view illustrating an embodiment of an electronic device according to the inventive concept.

Referring to FIG. 13, an electronic device DD-b in an embodiment may include light-emitting elements ED-1, ED-2 and ED-3 each including two stacked emission layers. Compared to the electronic device DD in an embodiment illustrated in FIG. 6, an embodiment illustrated in FIG. 13 is different in that each of first to third light-emitting elements ED-1, ED-2 and ED-3 includes the two emission layers stacked in the thickness direction. In each of the first to third light-emitting elements ED-1, ED-2 and ED-3, the two emission layers may emit light in the same wavelength region.

The first light-emitting element ED-1 may include a first red emission layer EML-R1 and a second red emission layer EML-R2. The second light-emitting element ED-2 may include a first green emission layer EML-G1 and a second green emission layer EML-G2. In addition, the third light-emitting element ED-3 may include a first blue emission layer EML-B1 and a second blue emission layer EML-B2. An emission auxiliary part OG may be disposed in each of spaces between the first red emission layer EML-R1 and the second red emission layer EML-R2, between the first green emission layer EML-G1 and the second green emission layer EML-G2, and between the first blue emission layer EML-B 1 and the second blue emission layer EML-B2.

The emission auxiliary part OG may include a single layer or a plurality of layers. The emission auxiliary part OG may include a charge generation layer. More specifically, the emission auxiliary part OG may include an electron transport region, the charge generation layer, and a hole transport region which are stacked in sequence. The emission auxiliary part OG may be provided as a common layer over the entirety of the first to third light-emitting elements ED-1, ED-2 and ED-3. However, the disclosure is not limited thereto, and the emission auxiliary part OG may be patterned in an opening portion OH defined in a pixel defining film PDL.

The first red emission layer EML-R1, the first green emission layer EML-G1, and the first blue emission layer EML-B1 may be disposed between the emission auxiliary part OG and an electron transport region ETR. The second red emission layer EML-R2, the second green emission layer EML-G2, and the second blue emission layer EML-B2 may be disposed between a hole transport region HTR and the emission auxiliary part OG.

That is, the first light-emitting element ED-1 may include a first electrode EL1, the hole transport region HTR, the second red emission layer EML-R2, the emission auxiliary part OG, the first red emission layer EML-R1, the electron transport region ETR, a second electrode EL2, and a capping layer CPL which are stacked in sequence. The second light-emitting elements ED-2 may include a first electrode EL1, the hole transport region HTR, the second green emission layer EML-G2, the emission auxiliary part OG, the first green emission layer EML-G1, the electron transport region ETR, the second electrode EL2, and the capping layer CPL which are stacked in sequence. The third light-emitting elements ED-3 may include a first electrode EL1, the hole transport region HTR, the second blue emission layer EML-B2, the emission auxiliary part OG, the first blue emission layer EML-B1, the electron transport region ETR, the second electrode EL2, and the capping layer CPL which are stacked in sequence.

An optical auxiliary layer PL may be disposed on a display element layer DP-ED. The optical auxiliary layer PL may not include a polarizing layer. The optical auxiliary layer PL may be disposed on a display panel DP and control reflected light from the display panel DP due to external light. Unlike the illustrated embodiment, the optical auxiliary layer PL may be omitted in the display device.

At least one of the second electrode EL2 and the capping layer CPL included in the electronic device DD-b in an embodiment illustrated in FIG. 13 may have the materials, the thicknesses, the refractive indexes, or the like, described above.

Unlike FIGS. 12 and 13, FIG. 14 illustrates an electronic device DD-c including four emission structures OL-B1, OL-B2, OL-B3 and OL-C1. A light-emitting element ED-CT may include a first electrode EL1 and a second electrode EL2 facing each other, and first to fourth emission structures OL-B1, OL-B2, OL-B3 and OL-C1 which are stacked in sequence between the first electrode EL1 and the second electrode EL2 in the thickness direction. Each of charge generation layers CGL1, CGL2 and CGL3 may be disposed in each space between the first to fourth emission structures OL-B1, OL-B2, OL-B3 and OL-C1 may include the emission layer. Among the four emission structures, the first to third emission structures OL-B1, OL-B2 and OL-B3 may emit blue light, and the fourth emission structure OL-C1 may emit green light. However, the disclosure is not limited thereto, and the first to fourth emission structures OL-B1, OL-B2, OL-B3 and OL-C1 may emit light in different wavelength regions. The light-emitting element ED-CT includes a capping layer CPL disposed on the second electrode EL2.

The charge generation layers CGL1, CGL2 and CGL3, each of which is disposed between neighboring emission structures of the first to fourth emission structures OL-B1, OL-B2, OL-B3 and OL-C1, may include a p-type charge generation layer and/or a n-type charge generation layer.

At least one of the emission structures OL-B1, OL-B2, OL-B3 and OL-C1 included in the electronic device DD-c in an embodiment may include the hole transport region described above. In an embodiment, like the embodiment described above, in an embodiment, at least one of the first to third emission structures OL-B1, OL-B2 and OL-B3 may include a first hole transport layer including a first hole transport material, and a portion of the first hole transport layer may include a structure doped with a p-type dopant, for example.

In an embodiment, the electronic device may include a display device including a plurality of light-emitting elements, and a controller which controls the display device. The electronic device in an embodiment may be a device that is activated in response to an electrical signal. The electronic device may include display devices according to various embodiments. In an embodiment, the electronic device may include large-sized display devices such as televisions, monitors, or outdoor billboards, and also in relatively small and medium-sized display devices such as personal computers, notebook computers, personal digital assistants, vehicle display devices, game consoles, portable electronic devices, or cameras, for example.

Hereinafter, a method for manufacturing a light-emitting element in an embodiment of the inventive concept will be described with reference to the accompanying drawings.

The method for manufacturing the light-emitting element in an embodiment includes forming, on a first electrode, a functional layer including at least an emission layer, forming a second electrode on the functional layer, and forming a capping layer on the second electrode. According to the method for manufacturing the light-emitting element in an embodiment, as illustrated in FIG. 7, a light-emitting element ED in which a first electrode EL1, a functional layer FL, a second electrode EL2, and a capping layer CPL are stacked in sequence may be manufactured. The functional layer FL may include a hole transport region HTR, an emission layer EML, and an electron transport region ETR.

In the method for manufacturing the light-emitting element in an embodiment, the forming of the second electrode includes forming a first layer on the functional layer, forming a second layer on the first layer by a different material from that of the first layer, and forming a third layer on the second layer by a different material from that of the second layer. According to the forming of the second electrode in an embodiment, as illustrated in FIGS. 10A to 10C, second electrodes EL2, EL2-1 and EL2-2 respectively including first layers L1, second layers L2, L2-1 and L2-2, and third layers L3 may be formed.

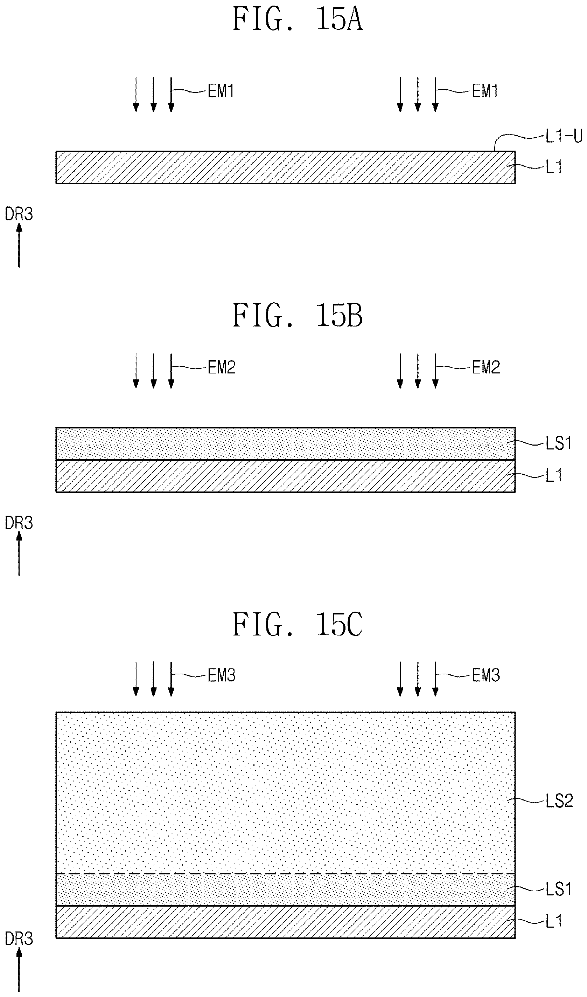

FIGS. 15A to 15D are cross-sectional views of an embodiment of some operations of a method for manufacturing a light-emitting element. In forming of a second electrode of the method for manufacturing the light-emitting element, operations included in forming of a second layer are illustrated in sequence in FIGS. 15A to 15D. The operations included in the forming of the second layer L2 illustrated in FIG. 10A are illustrated in sequence in FIGS. 15A to 15D.

Referring to FIGS. 10A, 15A, and 15B, the forming of the second layer L2 includes forming a first sub-layer LS1 on a first layer L1. The first sub-layer LS1 may be formed on a top surface L1-U of the first layer L1. The first sub-layer LS1 may be directly formed on the first layer L1.

A first deposition material EM1 may be provided to form the first sub-layer LS1. The first deposition material EM1 may be silver (Ag). The first sub-layer LS1 may be formed using pure silver. In the forming of the first sub-layer LS1, the first deposition material EM1 is provided at a first deposition rate. The first deposition material EM1 may be provided through a thermal evaporation process.

Referring to FIGS. 10A, 15B, and 15C, the forming of the second layer L2 includes forming a second sub-layer LS2 on the first sub-layer LS1. The second sub-layer LS2 may be directly formed on the first sub-layer LS1.

A second deposition material EM2 may be provided to form the second sub-layer LS2. The second deposition material EM2 may be silver (Ag). The second sub-layer LS2 may be formed using pure silver. In the forming of the second sub-layer LS2, the second deposition material EM2 is provided at a second deposition rate. The second deposition material EM2 may be provided through the thermal evaporation process.

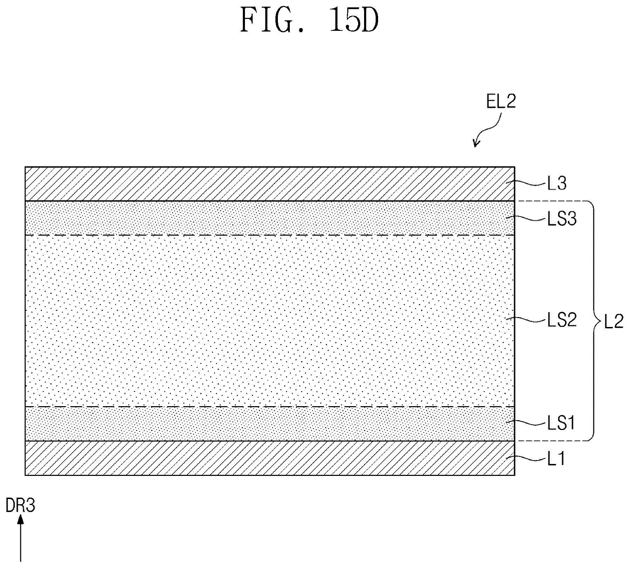

Referring to FIGS. 10A, 15C, and 15D, the forming of the second layer L2 includes forming a third sub-layer LS3 on the second sub-layer LS2. The third sub-layer LS3 may be directly formed on the second sub-layer LS2.

A third deposition material EM3 may be provided to form the third sub-layer LS3. The third deposition material EM3 may be silver (Ag). The third sub-layer LS3 may be formed using pure silver. In the forming of the third sub-layer LS3, the third deposition material EM3 is provided at a third deposition rate. The third deposition material EM3 may be provided through the thermal evaporation process.

FIGS. 15A to 15D, each of the first deposition material EM1, the second deposition material EM2, and the third deposition material EM3 may include silver (Ag) but not include other materials. The first sub-layer LS1, the second sub-layer LS2, and the third sub-layer LS3 may be formed using the same deposition materials EM1, EM2 and EM3, respectively, but have different film properties due to the different deposition rates.

In an embodiment, the first deposition rate, at which the first deposition material EM1 is provided, is different from the second deposition rate at which the second deposition material EM2 is provided. The second deposition rate, at which the second deposition material EM2 is provided, is different from the third deposition rate at which the third deposition material EM3 is provided. In an embodiment, the second deposition rate at which the second deposition material EM2 is provided to form the second sub-layer LS2 may be lower than the first deposition rate at which the first deposition material EM1 is provided to form the first sub-layer LS1. The second deposition rate at which the second deposition material EM2 is provided to form the second sub-layer LS2 may be lower than the third deposition rate at which the third deposition material EM3 is provided to form the third sub-layer LS3. The first deposition rate may be substantially the same as the third deposition rate.

As the second deposition rate may be lower than each of the first deposition rate and the third deposition rate, a film density of the second sub-layer LS2 may be lower than a film density of each of the first sub-layer LS1 and the third sub-layer LS3. Silver may be provided at the lower deposition rate in the forming of the second sub-layer LS2 than in the forming of each of the first sub-layer LS1 and the third sub-layer LS3, and thus the film density of the second sub-layer LS2 may be lower than each of the film density of the first sub-layer LS1 and the film density of the third sub-layer LS3.

The forming the first sub-layer LS1, the second sub-layer LS2, and the third sub-layer LS3 may be respectively performed while providing the same material in the same chamber and changing the deposition rate. The forming of the first sub-layer LS1, the second sub-layer LS2, and the third sub-layer LS3 may be respectively performed in the same chamber by adjusting opening/closing of a shutter of a supply port, through which silver is provided, to adjust the deposition rate. In an embodiment, in the second sub-layer LS2 formed at the lower deposition rate, silver may be deposited in a state in which the partial shutter of the supply port through which silver is provided is closed, and in the first sub-layer LS1 and the third sub-layer LS3 formed at the higher deposition rate, silver may be deposited in a state in which the partial shutter of the supply port through which silver is provided is opened, for example.

The second deposition rate may be about 1.8 angstroms per second (Å/s) to about 2.2 Å/s. The second deposition rate may be about 2.0 Å/s, for example. Each of the first deposition rate and the third deposition rate may be about 2.8 Å/s to about 3.2 Å/s. Each of the first deposition rate and the third deposition rate may be about 3.0 Å/s, for example.

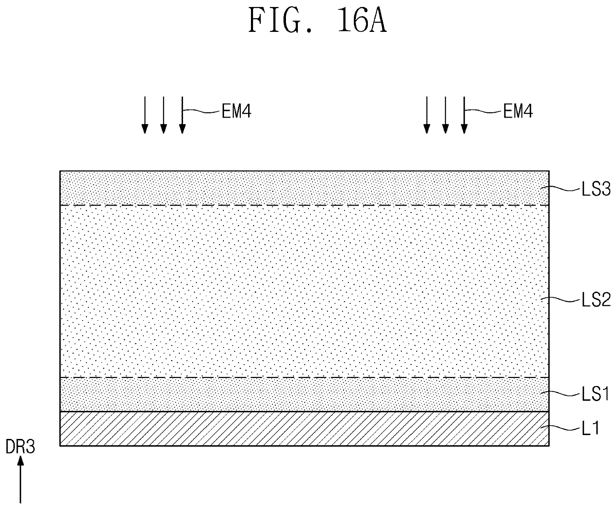

FIGS. 16A to 16C are cross-sectional views of an embodiment of some operations of a method for manufacturing a light-emitting element. In forming of a second electrode of the method for manufacturing the light-emitting element, additional operations included in forming of a second layer are illustrated in sequence in FIGS. 16A to 16C. Some additional operations in the forming of the second layer L2-2 illustrated in FIG. 10C are illustrated in sequence in FIGS. 16A to 16C.

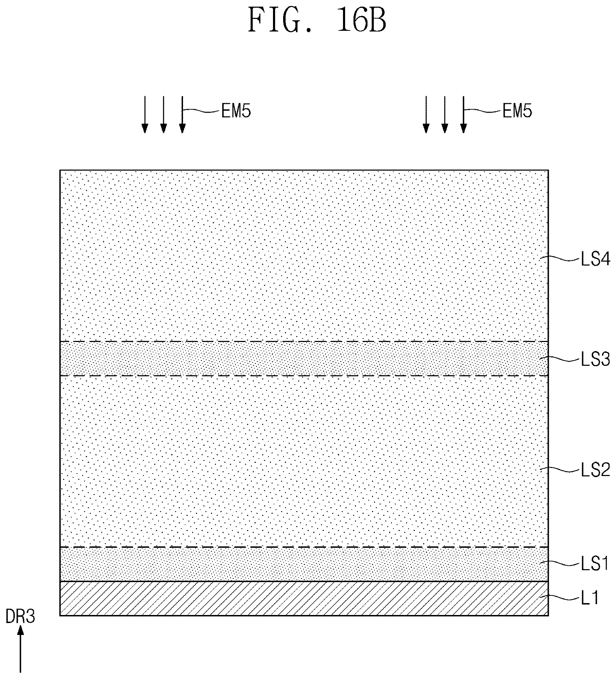

Referring to FIGS. 10C, 16A, and 16B, the forming of the second layer L2-2 may further include forming a fourth sub-layer LS4 on the third sub-layer LS3. The fourth sub-layer LS4 may be directly formed on the third sub-layer LS3.

A fourth deposition material EM4 may be provided to form the fourth sub-layer LS4. The fourth deposition material EM4 may be silver (Ag). The fourth sub-layer LS4 may be formed using pure silver. In the forming of the fourth sub-layer LS4, the fourth deposition material EM4 may be provided at a fourth deposition rate. The fourth deposition material EM4 may be provided through a thermal evaporation process.

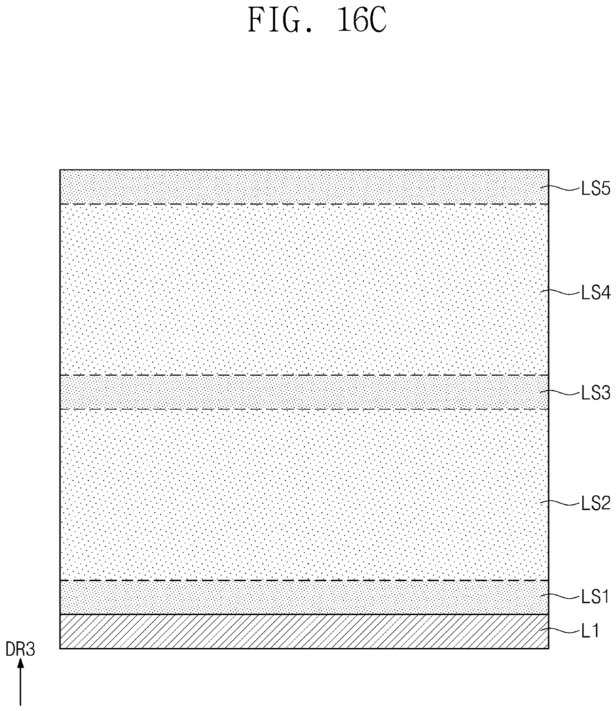

Referring to FIGS. 10C, 16B, and 16C, the forming of the second layer L2-2 may further include forming a fifth sub-layer LS5 on the fourth sub-layer LS4. The fifth sub-layer LS5 may be directly formed on the fourth sub-layer LS4.

A fifth deposition material EM5 may be provided to form the fifth sub-layer LS5. The fifth deposition material EM5 may be silver (Ag). The fifth sub-layer LS5 may be formed using pure silver. In the forming of the fifth sub-layer LS5, the fifth deposition material EM5 may be provided at a fifth deposition rate. The fifth deposition material EM5 may be provided through the thermal evaporation process.

In FIGS. 15A to 15D and 16A to 16C, each of the first deposition material EM1, the second deposition material EM2, the third deposition material EM3, the fourth deposition material EM4, and the fifth deposition material EM5 may include silver (Ag) but not include other materials. The first sub-layer LS1, the second sub-layer LS2, the third sub-layer LS3, the fourth sub-layer LS4, and the fifth sub-layer LS5 may be respectively formed using the same deposition materials EM1, EM2, EM3, EM4 and EM5, but have different film properties due to the different deposition rates.

In an embodiment, the third deposition rate at which the third deposition material EM3 is provided may be different from the fourth deposition rate at which the fourth deposition material EM4 is provided. The fourth deposition rate at which the fourth deposition material EM4 is provided may be different from the fifth deposition rate at which the fifth deposition material EMS is provided. In an embodiment, the fourth deposition rate at which the fourth deposition material EM4 is provided to form the fourth sub-layer LS4 may be lower than the third deposition rate at which the third deposition material EM3 is provided to form the third sub-layer LS3. The fourth deposition rate at which the fourth deposition material EM4 is provided to form the fourth sub-layer LS4 may be lower than the fifth deposition rate at which the fifth deposition material EM5 is provided to form the fifth sub-layer LS5. The third deposition rate may be substantially the same as the fifth deposition rate.

As the fourth deposition rate may be lower than each of the third deposition rate and the fifth deposition rate, a film density of the fourth sub-layer LS4 may be lower than a film density of each of the third sub-layer LS3 and the fifth sub-layer LS5, which are next (adjacent) to the fourth sub-layer LS4. Silver may be provided at the lower deposition rate in the forming of the fourth sub-layer LS4 than in forming of each of the third sub-layer LS3 and the fifth sub-layer LS5, and thus the film density of the fourth sub-layer LS4 may be lower than each of the film density of the third sub-layer LS3 and the film density of the fifth sub-layer LS5.

The light-emitting element in the embodiment may be excellent in luminous efficiency and element lifespan.

The electronic device including the light-emitting element in the embodiment may be improved in display efficiency.

According to the method for manufacturing the light-emitting element in the embodiment, the light-emitting element with the excellent element reliability may be manufactured through the short process time.

In the above, description has been made with reference to embodiments of the inventive concept, but those skilled or of ordinary skill in the art may understand that various modifications and changes may be made to the inventive concept insofar as such modifications and changes do not depart from the technical scope of the inventive concept set forth in the claims to be described later.

Therefore, the technical scope of the inventive concept is not to be limited to the contents stated in the detailed description of the specification, but should be determined by the claims.

## Claims

1. A light-emitting element (ED) comprising:
a first electrode (EL1);
a functional layer (FL) disposed on the first electrode (EL1) and comprising an emission layer (EML);
a second electrode (EL2) disposed on the functional layer (FL), the second electrode (EL2) comprising:
a first layer (L1) disposed on the functional layer (FL);
a second layer (L2) disposed on the first layer (L2) and comprising a different material from a material of the first layer (L1), the second layer (L2) further comprising:
a plurality of sub-layers each comprising silver (Ag), the plurality of sub-layers further comprising:
a first sub-layer (LS1) disposed on the first layer (L1);
a second sub-layer (LS2) disposed on the first sub-layer (LS1); and
a third sub-layer (LS3) disposed on the second sub-layer (LS2); and
a third layer (L3) disposed on the second layer (L2) and comprising a different material from a material of the second layer (L2); and
a capping layer (CPL) disposed on the second electrode (EL2),
wherein a film density of the first sub-layer (LS1) and a film density of the second sub-layer (LS2) are different, and the film density of the second sub-layer (LS2) and a film density of the third sub-layer (LS3) are different.

2. The light-emitting element (ED) of claim 1, wherein the film density of the second sub-layer (LS2) is lower than the film density of each of the first sub-layer (LS1) and the third sub-layer (LS3), and
the film density of the first sub-layer (LS1) and the film density of the third sub-layer (LS3) are substantially identical to each other.

3. The light-emitting element (ED) of claim 1, wherein the film density of the second sub-layer (LS2') is higher than the film density of each of the first sub-layer (LS1') and the third sub-layer (LS3'), and
the film density of the first sub-layer (LS1') and the film density of the third sub-layer (LS3') are substantially identical to each other.

4. The light-emitting element (ED) of any one of claims 1 to 3, wherein the plurality of sub-layers further comprise:
a fourth sub-layer (LS4) disposed on the third sub-layer (LS3); and
a fifth sub-layer (LS5) disposed on the fourth sub-layer (LS4),
wherein the film density of the third sub-layer (LS3) and a film density of the fourth sub-layer (LS4) are different, and the film density of the fourth sub-layer (LS4) and a film density of the fifth sub-layer (LS5) are different.

5. The light-emitting element (ED) of any one of claims 1 to 4, wherein the second sub-layer (LS2) is directly disposed on the first sub-layer (LS1), and
the third sub-layer (LS3) is directly disposed on the second sub-layer (LS2).

6. The light-emitting element (ED) of any one of claims 1 to 5, wherein the first sub-layer (LS1), the second sub-layer (LS2), and the third sub-layer (LS3) have a shape of a single body.

7. The light-emitting element (ED) of any one of claims 1 to 6, wherein the first layer (L1) is directly disposed on the functional layer (FL),
the second layer (L2) is directly disposed on the first layer (L1), and
the third layer (L3) is directly disposed on the second layer (L2).

8. The light-emitting element (ED) of any one of claims 1 to 7, wherein the functional layer (FL) comprises:
a hole transport region (HTR) disposed on the first electrode (EL1);
the emission layer (EML) disposed on the hole transport region (HTR); and
an electron transport region (ETR) disposed on the emission layer (EML),
wherein the first layer (L1) is directly disposed on the electron transport region (ETR), and
the capping layer (CPL) is directly disposed on the third layer (L3).

9. The light-emitting element (ED) of any one of claims 1 to 8, wherein the second electrode (EL2) is a cathode.

10. The light-emitting element (ED) of any one of claims 1 to 9, wherein the first sub-layer (LS1) has a thickness of about 20 angstroms to about 30 angstroms,
the second sub-layer (LS2) has a thickness of about 50 angstroms to about 70 angstroms, and
the third sub-layer (LS3) has a thickness of about 20 angstroms to about 30 angstroms.

11. The light-emitting element (ED) of any one of claims 1 to 10, wherein the first layer (L1) has a thickness of about 5 angstroms to about 30 angstroms,
the second layer (L2) has a thickness of about 90 angstroms to about 300 angstroms, and
the third layer (L3) has a thickness of about 5 angstroms to about 30 angstroms.

12. The light-emitting element (ED) of any one of claims 1 to 11, wherein each of the first layer (L1) and the third layer (L3) comprises a halogenated metal, a lanthanum group metal, or a co-deposition material of a halogenated metal and a lanthanum group metal.

13. The light-emitting element (ED) of any one of claims 1 to 12, wherein each of the first sub-layer (LS1), the second sub-layer (LS2), and the third sub-layer (LS3) comprises silver (Ag).

14. An electronic device (DD) comprising:
a base layer (BS);
a circuit layer disposed on the base layer (DP-CL); and
a display element layer (DP-ED) disposed on the circuit layer (DP-CL) and comprising:
a light-emitting element (ED), the light-emitting element (ED) comprising:
a first electrode (EL1);
a functional layer (FL) disposed on the first electrode (EL1) and comprising an emission layer (EML); and
a second electrode (EL2) disposed on the functional layer (FL), the second electrode (EL2) comprising:
a first layer (L1) disposed on the functional layer (FL);
a second layer (L2) disposed on the first layer (L1) and comprising a different material from a material of the first layer (L1), the second layer (L2) further comprising:
a plurality of sub-layers each comprising silver (Ag), the plurality of sub-layers further comprising:
a first sub-layer (LS1) disposed on the first layer (L1);
a second sub-layer (LS2) disposed on the first sub-layer (LS1); and
a third sub-layer (LS3) disposed on the second sub-layer (LS2); and
a third layer (L3) disposed on the second layer (L2) and comprising a different material from a material of the second layer (L2),
wherein a film density of the second sub-layer (LS2) is lower than a film density of each of the first sub-layer (LS1) and the third sub-layer (LS3), and
wherein the film density of the first sub-layer (LS1) and the film density of the third sub-layer (LS3) are substantially identical to each other.

15. A method for manufacturing a light-emitting element (ED), the method comprising:
forming, on a first electrode (EL1), a functional layer (FL) including an emission layer (EML);
forming a second electrode (EL2) on the functional layer (FL); and
forming a capping layer (CPL) on the second electrode (EL2),
wherein the forming the second electrode (EL2) comprises:
forming a first layer (L1) on the functional layer (FL);
forming a second layer (L2) on the first layer (L1) by a different material from a material of the first layer (L1); and
forming a third layer (L3) on the second layer (L2) by a different material from a material of the second layer (L2),
wherein the forming the second layer (L2) comprises:
depositing silver (Ag) onto the first layer (L1) at a first deposition rate to form a first sub-layer (LS1);
depositing silver (Ag) onto the first sub-layer (LS1) at a second deposition rate to form a second sub-layer (LS2); and
depositing silver (Ag) onto the second sub-layer (LS2) at a third deposition rate to form a third sub-layer (LS3),
wherein the first deposition rate and the second deposition rate are different, and the second deposition rate and the third deposition rate are different.
